(19) Europäisches Patentamt

European Patent Office

Office européen des brevets

(11) **EP 1 269 633 B1**

(12) **EUROPÄISCHE PATENTSCHRIFT**

(45) Veröffentlichungstag und Bekanntmachung des Hinweises auf die Patenterteilung:
**02.06.2004 Patentblatt 2004/23**

(21) Anmeldenummer: **01923516.7**

(22) Anmeldetag: **12.03.2001**

(51) Int Cl.⁷: **H03M 13/29**

(86) Internationale Anmeldenummer:
**PCT/DE2001/000983**

(87) Internationale Veröffentlichungsnummer:
**WO 2001/069789 (20.09.2001 Gazette 2001/38)**

(54) **OPTIMIERTER TURBO-DECODIERER**

OPTIMIZED TURBO DECODER

DECODEUR TURBO OPTIMISE

(84) Benannte Vertragsstaaten:
**AT BE CH CY DE DK ES FI FR GB GR IE IT LI LU MC NL PT SE TR**

(30) Priorität: **16.03.2000 DE 10012873**

(43) Veröffentlichungstag der Anmeldung:
**02.01.2003 Patentblatt 2003/01**

(73) Patentinhaber: **Infineon Technologies AG**
**81669 München (DE)**

(72) Erfinder:
- **SCHMIDT, Peter**
  **67158 Ellerstadt (DE)**
- **PLECHINGER, Jörg**
  **80469 München (DE)**
- **SCHNEIDER, Michael**
  **81541 München (DE)**
- **DOETSCH, Markus**
  **Ch-3098 Schliern (CH)**
- **KELLA, Tideya**
  **80337 München (DE)**
- **JUNG, Peter**
  **67697 Otterberg (DE)**
- **BECKER, Burkhard**
  **85737 Ismaning (DE)**

(74) Vertreter: **Lange, Thomas, Dr. et al**
**Patentanwälte**
**Lambsdorff & Lange**
**Dingolfinger Strasse 6**
**81673 München (DE)**

(56) Entgegenhaltungen:
**EP-A- 0 713 337**

- **PIETROBON S S: "IMPLEMENTATION AND PERFORMANCE OF A TURBO/MAP DECODER" INTERNATIONAL JOURNAL OF SATELLITE COMMUNICATIONS, JOHN WILEY AND SONS, US, Bd. 16, Nr. 1, 1998, Seiten 23-46, XP000856961 ISSN: 0737-2884**
- **BERENS F ET AL: "IMPLEMENTATION ASPECTS OF TURBO-DECODERS FOR FUTURE RADIO APPLICATIONS" VTC 1999-FALL. IEEE VTS 50TH. VEHICULAR TECHNOLOGY CONFERENCE. GATEWAY TO THE 21ST. CENTURY COMMUNICATIONS VILLAGE. AMSTERDAM, SEPT. 19 - 22, 1999, IEEE VEHICULAR TECHNOLGY CONFERENCE, NEW YORK, NY: IEEE, US, Bd. 5 CONF. 50, 19. September 1999 (1999-09-19), Seiten 2601-2605, XP000922227 ISBN: 0-7803-5436-2**
- **VOGT J ET AL: "COMPARISON OF DIFFERENT TURBO DECODER REALIZATIONS FOR IMT-2000" 1999 IEEE GLOBAL TELECOMMUNICATIONS CONFERENCE. GLOBECOM'99. SEAMLESS INTERCONNECTION FOR UNIVERSAL SERVICES. RIO DE JANEIRO, BRAZIL, DEC. 5-9, 1999, IEEE GLOBAL TELECOMMUNICATIONS CONFERENCE, NEW YORK, NY: IEEE, US, Bd. 5, 5. Dezember 1999 (1999-12-05), Seiten 2704-2708, XP000958609 ISBN: 0-7803-5797-3**
- **DAWID AND H MEYR H: "Scalable Architectures for High Speed Channel Decoding" VLSI SIGNAL PROCESSING, PROCEEDINGS. IEEE WORKSHOP ON VLSI SIGNAL PROCESSING, XX, XX, 26. Oktober 1994 (1994-10-26), Seiten 226-235, XP002132423**

EP 1 269 633 B1

- DAWID H ET AL: "Real-time algorithms and VLSI architectures for soft output MAP convolutional decoding" PERSONAL, INDOOR AND MOBILE RADIO COMMUNICATIONS, 1995. PIMRC'95. WIRELESS: MERGING ONTO THE INFORMATION SUPERHIGHWAY., SIXTH IEEE INTERNATIONAL SYMPOSIUM ON TORONTO, ONT., CANADA 27-29 SEPT. 1995, NEW YORK, NY, USA,IEEE, US, 27. September 1995 (1995-09-27), Seiten 193-197, XP002176458 ISBN: 0-7803-3002-1

**Beschreibung**

Die Erfindung betrifft einen Turbo-Decodierer zum Decodieren eines senderseitig mit einem Turbo-Code fehlerschutzcodierten, über einen gestörten Kanal übertragenen und in einem Empfänger detektierten Datensignals nach dem Oberbegriff des Anspruchs 1.

Ein Grundproblem der Nachrichtentechnik besteht darin, ein Datensignal möglichst fehlerfrei über einen gestörten Kanal zu übertragen. Um dies zu erreichen, wird das zu übertragende Datensignal einer Kanalcodierung unterzogen. Durch die Kanalcodierung wird das zu übertragende Signal an die Eigenschaften des Übertragungskanals angepaßt. Es sind eine Vielzahl unterschiedlicher Kanalcodierverfahren im Einsatz. Das Prinzip der Kanalcodierung (die auch als Fehlerschutzcodierung bezeichnet wird) beruht darauf, daß durch gezieltes Einbringen von Redundanz in das zu übertragende Signal ein effektiver Fehlerschutz erreicht wird.

Besondere Schwierigkeiten im Zusammenhang mit der Signalübertragung ergeben sich bei Mobilfunksystemen. Dies ist einerseits darauf zurückzuführen, daß bei Mobilfunksystemen aufgrund von zeitvarianten Mehrfachreflektionen, Gleichkanalstörungen, Dopplerverschiebung und Rauschen ausgesprochen starke Signalverzerrungen am Empfänger auftreten. Andererseits stehen im Empfänger einer Mobilstation aus Platz- und Kostengründen nur begrenzte Energie- und Hardware-Resourcen zur Verfügung. In der Mobilfunktechnik wird daher angestrebt, mit möglichst wenig Signalverarbeitungsaufwand (Schonung der Resource Energie) möglichst Hardware-effizient (d.h. platz- und kostengünstig) eine Rekonstruktion des gesendeten Signals mit möglichst geringer Fehlerrate zu erreichen.

Es ist ersichtlich, daß die genannten Forderungen in der Regel nicht gleichzeitig optimierbar sind, sondern daß ein sinnvoller Ausgleich oder Kompromiß zwischen diesen Forderungen durch eine gezielte Software/Hardware-Auslegung des Empfängers geschaffen werden muß.

Ein modernes Verfahren der Fehlerschutzcodierung ist die sogenannte "Turbo-Codierung". Bei der Turbo-Codierung werden sogenannte "Turbo-Codes" eingesetzt. Turbo-Codes sind binäre, parallel verkettete rekursive Faltungscodes. Turbo-Codes stellen insbesondere bei der Übertragung großer Datenblöcke eine ausgesprochen leistungsfähige Form der Fehlerschutzcodierung dar.

Zum Decodieren von Turbo-Codes wird im Empfänger ein Turbo-Decodierer eingesetzt. Ein solcher ist in dem Buch "Analyse und Entwurf digitaler Mobilfunksysteme" von P. Jung, Stuttgart, B.G. Teubner, 1997, auf den Seiten 343 bis 368, insbesondere Bild E.2, beschrieben. Dieser Turbo-Decodierer besteht aus zwei rekursiv verschalteten MAP-Symbolschätzern, zwischen welchen ein Turbo-Code-Verschachteler angeordnet ist.

Ein Hindernis bei der Implementierung von Turbo-Codes besteht darin, daß Turbo-Decodierer aufgrund der iterativen Signalverarbeitung und der zwei MAP-Symbolschätzer einen beträchtlichen Signalverarbeitungs- und Hardware-Aufwand erfordern.

Bisher werden Turbo-Codes daher nur bei weniger resourcenbegrenzten Systemen, wie beispielsweise Satellitenkommunikationssystemen, eingesetzt. Im Bereich des Mobilfunks sind Turbo-Codes aufgrund der genannten Beschränkungen noch nicht im Einsatz.

In der den nächstliegenden Stand der Technik repräsentierenden Veröffentlichung von S. Pietrobon ("Implementation and Performance of a Turbo/MAP Decoder", Int. J. Satell. Commun., 16, 1998) ist eine Implementierung eines Turbo-Decodierers beschrieben, bei der die Turbo-Decodier-spezifischen Berechnungs-Einheiten BMC (Branch Metric Calculator), SMC (State Metric Calculator) und LLRC (Log Likelihood Ratio Calculator) in Hardware ausgeführt sind.

Darüber hinaus offenbart Dokument EP 0 713 337 (A) einen für eine Mehrzahl von Modulationsformaten einstellbaren Viterbi Decodierer mit einer Einheit zum Berechnen von Übergangsmetriken, bestehend aus einer in einem RAM gespeicherten programmierbaren Nachschfagtabelle für I und Q Werte und einer Schaltung aus kombinatorischer Logik.

In der Veröffentlichung von F. Berens ("Implementation Aspects of Turbo-Decoders for Future Radio Applications", VTC'99, Sept. 1999) werden verschiedene Realisierungsmöglichkeiten von Turbo-Decodierern diskutiert. Dabei werden die Vor- und Nachteile der verschiedenen Realisierungsformen insbesondere hinsichtlich Schaltungsaufwand, Decodierungsgeschwindigkeit und Verlustleistung gegenüber gestellt.

Der Erfindung liegt die Aufgabe zugrunde, einen Turbo-Decodierer zu schaffen, der bei vertretbarem Hardware-Aufwand eine signalverarbeitungsarme und damit Energieresourcen-schonende Signaldecodierung ermöglicht. Insbesondere soll der erfindungsgemäße Turbo-Decodierer zum Einsatz in Mobilfunkempfängern geeignet sein.

Zur Lösung der Aufgabe sind die Merkmale des Anspruchs 1 vorgesehen.

Demnach besteht das Konzept der Erfindung darin, durch einen in einem Rechenmittel vorgesehenen ersten Hardware-Rechenbaustein bestehend aus kombinatorischer Logik eine gezielte Beschleunigung der Signalverarbeitung bei der Berechnung von Übergangs-Metrikwerten herbeizuführen, so daß eine zeit- und energieaufwendige Programm-Abarbeitung an dieser Stelle entfällt. Dadurch kann der gesamte Turbo-Decodier-Ablauf wesentlich beschleunigt werden. Das Rechenmittel und der darin enthaltene erste Hardware-Rechenbaustein sind dabei Teil eines bei der Turbo-Decodierung verwendeten Symbolschätzers. Darüber hinaus weist der Symbolschätzer ein Steuermittel zur Steuerung des ersten Hardware-Rechenbausteins auf, welches bewirkt, daß der erste Rechenbaustein die Übergangs-Metrikwerte wechselweise nach einer ersten und einer zweiten Rechenvorschrift bestimmt. Dies bietet den Vorteil, daß bei der Turbo-Decodierung ein Symbolschätzer für beide MAP-Symbolschätzungen in dem Turbo-Decodier-Ablauf einsetzbar ist.

Eine vorteilhafte Ausführungsform des erfindungsgemäßen Turbo-Decodierers kennzeichnet sich dadurch, daß das Rechenmittel einen ersten Hardware-Rechenbaustein zur Erzeugung von Übergangs-Metrikwerten enthält, welcher vier parallel angeordnete Addierer und wenigstens eine den Addierern nachgeschaltete Zweier-Komplement-Stufe umfaßt. Auf diese Weise können in kürzester Zeit gleichzeitig sechzehn Übergangs-Metriken (die acht unterschiedliche Werte annehmen können) berechnet werden.

Eine weitere vorteilhafte Ausgestaltung des erfindungsgemäßen Turbo-Decodierers kennzeichnet sich dadurch, daß das Rechenmittel einen zweiten Hardware-Rechenbaustein zur Erzeugung von Vorwärts- und Rückwärtsrekursions-Metrikwerten enthält, welcher eine Additionsstufe bestehend aus einer Anzahl Q von parallel angeordneten Addierern, und eine Maximierungsstufe bestehend aus parallel angeordneten Maximum-Einheiten umfaßt, wobei jede Maximum-Einheit an ihren Eingängen die Ausgänge von zwei Addierern entgegennimmt und den größeren der Addiererausgänge an ihrem Ausgang ausgibt. Auf diese Weise können in kürzester Zeit gleichzeitig acht Vorwärts- oder Rückwärtsrekursions-Metrikwerte berechnet werden.

Vorzugsweise umfaßt der Symbolschätzer ein Steuermittel zur Steuerung des zweiten Hardware-Rechenbausteins, welches bewirkt, daß zur Berechnung der Vorwärts- und Rückwärtsrekursions-Metrikwerte Vorwärts- und Rückwärtsrekursionsintervalle mit gleitenden Intervallgrenzen innerhalb eines Datenblocks eingesetzt werden.

Eine schnelle Berechnung von Ausgabewerten wird durch das Vorsehen eines dritten Hardware-Rechenbausteins erreicht, welcher eine Additionsstufe bestehend aus einer Anzahl P von parallel angeordneten Addierern und eine Maximierungsstufe bestehend aus zwei parallel angeordneten Maximum-Einheiten umfaßt, wobei jede Maximum-Einheit an ihren Eingängen die Ausgänge von P/2 Addierern entgegennimmt und den größten der Addiererausgänge an ihrem Ausgang ausgibt.

Selbstverständlich kann das Rechenmittel auch alle drei genannten Hardware-Rechenbausteine umfassen. In diesem Fall sind in dem Rechenmittel drei festverschaltete Datenpfade realisiert, welche die wichtigsten Berechnungsschritte in direkter Signalverarbeitung (ohne Programmabarbeitung) ausführen.

Vorzugsweise umfaßt der erfindungsgemäße Turbo-Decodierer ferner einen digitalen Signalprozessor (DSP) zur Durchführung von Turbo-Ver- und Entschachtelungsprozeduren und zur Berechnung von für den momentanen Kanalzustand repräsentativer statistischer Information gemäß einem vorgegebenen Ablaufprogramm. Dabei steht der DSP über eine bidirektionale Schnittstelle mit dem Symbolschätzer in Datenaustauschverbindung. Mit anderen Worten wird der Turbo-Decodierer in einen auf Software-Abarbeitung basierenden Rechenabschnitt (DSP mit Ablaufprogramm) und einen im wesentlichen auf Hardware-Ebene arbeitenden Rechenabschnitt (Symbolschätzer) aufgeteilt. Diese Aufteilung, bei der der Datentransfer zwischen den beiden Rechenabschnitten durch die bidirektionale Schnittstelle realisiert wird, hat sich unter dem Gesichtspunkt eines Kompromisses zwischen aufwandsgünstiger Signalverarbeitung und vertretbarem Hardware-Aufwand als besonders vorteilhaft herausgestellt.

Eine weitere vorteilhafte Variante des erfindungsgemäßen Turbo-Decodierers kennzeichnet sich dadurch, daß der Symbolschätzer während einer Iterationsschleife der Turbo-Decodier-Prozedur sowohl zur Berechnung von erster als auch zur Berechnung von zweiter Zuverlässigkeitsinformation herangezogen wird. Diese gemultiplexte Ansteuerung des Symbolschätzers bewirkt, daß der (bei Turbo-Code-Decodierung notwendigerweise erhebliche) Hardware-Aufwand noch in akzeptablen Grenzen gehalten werden kann.

Weitere vorteilhafte Ausgestaltungen der Erfindung sind in den Unteransprüchen angegeben.

Die Erfindung wird nachfolgend anhand eines Ausführungsbeispiels unter Bezugnahme auf die Zeichnung erläutert; in dieser zeigt:

Fig. 1    eine schematische Darstellung der Luftschnittstelle eines Mobilfunksystems mit Sender und Empfänger;

Fig. 2    ein Blockschaltbild eines Turbo-Codierers zur Erzeugung eines Turbo-Codes;

Fig. 3    ein Blockschaltbild eines in Fig. 2 dargestellten RSC-Faltungscodierers;

Fig. 4    ein Funktions-Blockschaltbild zur Erläuterung der Arbeitsweise eines erfindungsgemäßen Turbo-Decodierers;

Fig. 5    ein Blockschaltbild des in Fig. 4 dargestellten Turbo-Decodierers;

Fig. 6    ein vereinfachtes Blockschaltbild des in Fig. 5 dargestellten MAP-Decodierers;

Fig. 7    eine schematische Darstellung zur Erläuterung einer segmentweisen Vorwärts- und Rückwärtsrekursionen bei der Berechnung von Zuverlässigkeitsinformation;

Fig. 8    ein Blockschaltbild der in Fig. 6 dargestellten Steuereinheit zur Erzeugung von standardspezifischer Code-Information;

Fig. 9a    ein Schaubild, in welchem die möglichen Übergänge zwischen den Anfangs- und Endzuständen eines Turbo-Codierers bei Eingabe eines Bits des Wertes 0 dargestellt sind;

Fig. 9b    ein Schaubild, in welchem die möglichen Übergänge zwischen den Anfangs- und Endzuständen eines Turbo-Codierers bei Eingabe eines Bits des Wertes 1 dargestellt sind;

Fig. 9c    ein Schaubild, in welchem vier Gruppen von Übergängen, geordnet nach den Endzuständen, dargestellt sind;

Fig. 9d    ein Blockschaltbild einer Rechenstufe zur Berechnung von theoretischer Information eines Turbo-Codes; und

Fig. 10    ein Blockschaltbild der Hardware-Architektur des in Fig. 6 dargestellten MAP-Decodierers.

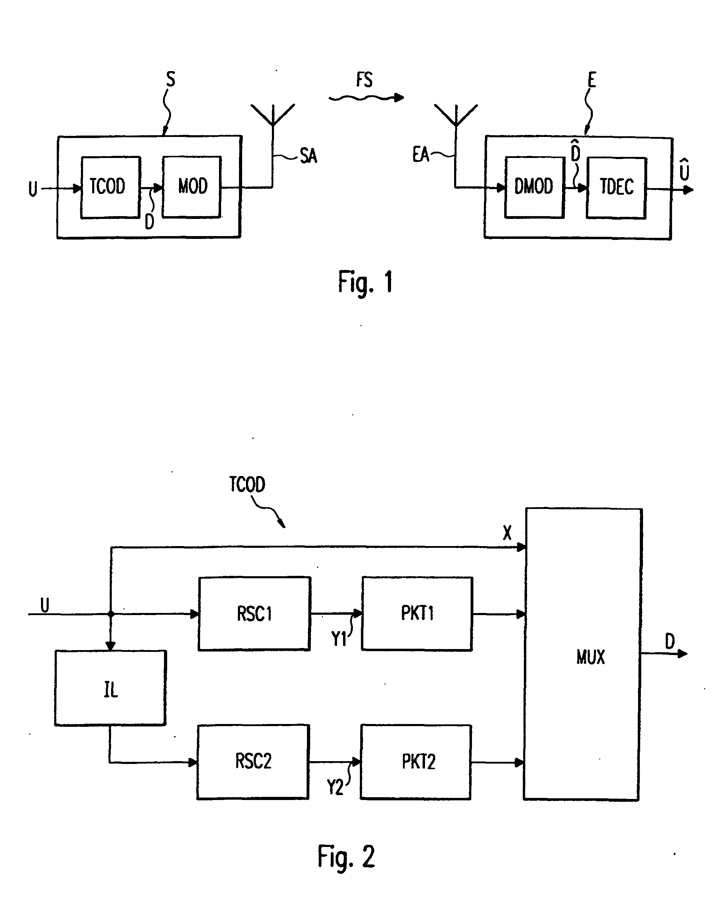

Fig. 1 zeigt einen Sender S und einen Empfänger E eines Mobilfunksystems. Der Sender S ist beispielsweise in einer Basisstation und der Empfänger E in einer Mobilstation des Mobilfunksystems enthalten.

Der Sender S weist einen Turbo-Codierer TCOD, einen Modulator MOD sowie eine Sendeantenne SA auf.

Der Turbo-Codierer TCOD nimmt ein digitales Eingabesignal in Form von Datensymbolen (beispielsweise Bits) $u_1$, $u_2$, .. entgegen. Im folgenden wird aufgrund der blockweisen Codierung eine endliche Folge U = ($u_1$, $u_2$, .., $u_N$) bestehend aus N Eingabesignal-Datensymbolen (z.B. Bits) $u_n$, n = 1, 2, .., N betrachtet, wobei die Anzahl N als Blockgröße bezeichnet wird.

Das Eingabesignal trägt eine zu übertragende Nutzinformation, beispielsweise eine Sprachnachricht. Es kann z.B. über eine Mikrophon-Verstärker-Analog/Digital-Umsetzer Schaltungskette (nicht dargestellt) erzeugt werden.

Der Turbo-Codierer TCOD fügt dem digitalen Eingabesignal zur Fehlerschutzcodierung Redundanz hinzu. Am Ausgang des Turbo-Codierers TCOD liegt ein fehlerschutzcodiertes Datensignal in Form einer Folge D bestehend aus K Datensymbolen (Bits), D = ($d_1$, $d_2$, .., $d_k$) vor.

Das Verhältnis N/K (Anzahl von Eingabebits/Anzahl von Ausgangsbits) wird als Coderate $R_c$ eines Codierers bezeichnet.

Ein Modulator MOD moduliert das fehlerschutzcodierte Datensignal auf ein Trägersignal auf. Das mit dem fehlerschutzcodierten Datensignal modulierte Trägersignal wird in nicht dargestellter Weise von einem Sendefilter spektral geformt und von einem Sendeverstärker verstärkt, bevor es als Funksignal FS über die Sendeantenne SA abgestrahlt wird.

Der Empfänger E weist eine Empfangsantenne EA, einen Demodulator DMOD und einen Turbo-Decodierer TDEC auf.

Die Empfangsantenne EA empfängt das durch Umgebungseinflüsse und Interferenz mit Funksignalen anderer Teilnehmer gestörte Funksignal FS und führt es dem Demodulator DMOD zu.

Der Demodulator DMOD entzerrt das empfangene Funksignal FS unter Berücksichtigung der im Funkkanal erlittenen Signalstörungen. Ein am Ausgang des Demodulators DMOD bereitgestelltes entzerrtes Datensignal liegt in Form einer Datensymbolfolge D = ($d_1$, $d_2$, .., $d_K$) vor, deren Elemente $d_1$, $d_2$, .., $d_K$ wertekontinuierliche Schätzwerte der Datensymbole $d_1$, $d_2$, .., $d_K$ der fehlerschutzcodierten Datensymbolfolge D sind.

Das entzerrte Datensignal wird dem Turbo-Decodierer TDEC zugeführt, an dessen Ausgang eine decodierte Ausgabesignalfolge Û = ($û_1$, $û_2$, .., $û_N$) bereitgestellt wird. Die Elemente $û_1$, $û_2$, .., $û_N$ der decodierten Ausgabesignalfolge Û sind Hypothesen der Datensymbole $u_1$, $u_2$, .., $u_N$ des senderseitigen Eingabesignals in Form von diskreten Werten aus dem Symbolvorrat (beispielsweise 0,1) des Eingabesignals.

Die Datensymbol-Fehlerrate wird durch die relative Häufigkeit von Fehlschätzungen $u_n \neq û_n$, n = 1, 2, .. definiert. Sie darf bei Mobilfunkanwendungen einen bestimmten maximal zulässigen Wert nicht überschreiten.

Vor der Beschreibung eines Ausführungsbeispiels des erfindungsgemäßen Turbo-Decodierers wird zum besseren Verständnis der Erfindung anhand Fig. 2 zunächst beispielhaft die Erzeugung eines Turbo-Codes erläutert.

Ein Turbo-Codierer TCOD weist zwei identische binäre rekursive systematische Faltungscodierer RSC1 und RSC2 auf, die in der Codiertechnik als RSC-(Recursive Systematic Convolutional-)Codierer bekannt sind. Dem zweiten RSC-Faltungscodierer RSC2 ist eingangsseitig ein Turbo-Code-Verschachteler IL vorgeschaltet, der eine blockweise Verschachtelung des Eingabedatensignals vornimmt. Die Ausgänge der beiden Faltungscodierer RSC1 und RSC2 sind jeweils über Punktierer PKT1 bzw. PKT2 mit einer Multiplexereinrichtung MUX verbunden. Der Multiplexereinrichtung MUX wird ferner eine Signalfolge X zugeführt, die identisch mit der digitalen Eingabesignalfolge U ist.

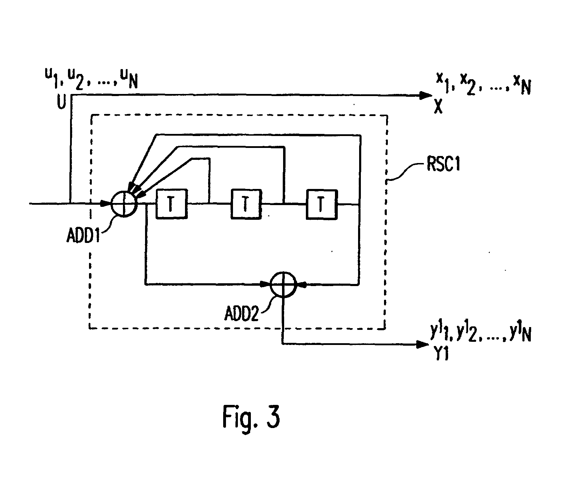

Fig. 3 zeigt am Beispiel von RSC1 den Aufbau eines rekursiven Faltungscodierers. Der Faltungscodierer RSC1 weist eingangsseitig einen ersten Addierer ADD1 und ein dem ersten Addierer ADD1 nachgeschaltetes Schieberegister mit z.B. drei Speicherzellen T auf. An seinem Ausgang stellt der Faltungscodierer RSC1 eine Redundanz-Datenfolge $Y1 = (y1_1, y1_2, .., y1_N)$ bereit, die von einem zweiten Addierer ADD2 gebildet wird.

Es wird deutlich, daß ein zu einem bestimmten Zeitpunkt n am Ausgang vorliegendes Redundanz-Datensymbol $y1_n$ (n = 1, 2, .., N) von dem aktuellen Eingabe-Datensymbol $u_n$ der Eingabesignalfolge U sowie von dem Zustand des Schieberegisters abhängt.

Der Aufbau des zweiten Faltungscodierers RSC2 ist identisch mit dem Aufbau des ersten Faltungscodierers RSC1; an seinem Ausgang stellt RSC2 eine Redundanz-Datenfolge $Y2 = (y2_1, y2_2, .., y2_N)$ bereit.

Die Signalfolge X kann als zweiter Ausgang des ersten Faltungscodierers RSC1 angesehen werden, das heißt bei dieser Betrachtungsweise umfaßt der erste Faltungscodierer RSC1 einen zweiten Ausgang, an dem die Datenfolge X ausgegeben wird, deren Elemente $x_1, x_2, .., x_N$ identisch mit den Elementen $u_1, u_2, .., u_N$ der Eingabesignalfolge U sind. Analoges gilt für den zweiten Faltungscodierer RSC2 und einen zweiten Ausgang X_I (nicht dargestellt) desselben, der identisch mit der verschachtelten Eingabesignalfolge U ist. Codierer mit dieser Eigenschaft werden allgemein als systematische Codierer bezeichnet.

Es werden dann pro Eingabe-Datensymbol $u_n$ von jedem Faltungscodierer RSC1 bzw. RSC2 genau zwei Ausgabe-Datensymbole $x_n$ und $y1_n$ bzw. $x\_I_n$ (verschachtelte systematische Information) und $y2_n$ ausgegeben. Jeder Faltungscodierer RSC1, RSC2 weist somit eine Coderate $R_c = 0{,}5$ auf.

Die Multiplexereinrichtung MUX dient zur Einstellung der Coderate des Turbo-Codierers TCOD. Um auch für TCOD eine Coderate von z.B. $R_c = 0{,}5$ zu erreichen, werden die beiden Redundanz-Teilfolgen Y1 und Y2 beispielsweise alternierend punktiert und multiplexiert. Die sich dabei ergebende Redundanz-Datenfolge $Y = (y1_1, y2_2, y1_3, y2_4, .., y1_N, y2_N)$ wird nachfolgend alternierend mit der systematischen Datenfolge X multiplexiert. Das sich bei dieser (speziellen) Form der Turbocodierung ergebende fehlerschutzcodierte Datensignal weist demzufolge (N sei als eine gerade Zahl angenommen) beispielsweise die Form $D = (x_1, y1_1, x_2, y2_2, x_3, y1_3, x_4, y2_4, .., x_N, y2_N)$ auf.

Der Faltungscodierer RSC1 kann als endlicher, getakteter Automat aufgefaßt und durch ein sog. Trellis-Diagramm mit M möglichen Zuständen beschrieben werden. Das Trellis-Diagramm des Faltungscodierers RSC1 mit einem Schieberegister aus 3 Zellen weist $M = 2^3 = 8$ Knoten auf, die den möglichen Zuständen des Schieberegisters entsprechen. Ein (beliebiger) erster Zustand m', der durch Eingabe eines Eingangsbits ($u_n$ = 0 oder 1) in einen zweiten Zustand m übergeht, ist mit diesem im Trellis-Diagramm durch eine Verbindungslinie verbunden. Jede Redundanz-Teilfolge Y1 entspricht einem bestimmten Weg entlang Verbindungslinien durch das Trellis-Diagramm des RSC1-Codierers.

Trellis-Diagramme zur Veranschaulichung der Zustände von Codierern sind bekannt und werden hier nicht näher erläutert.

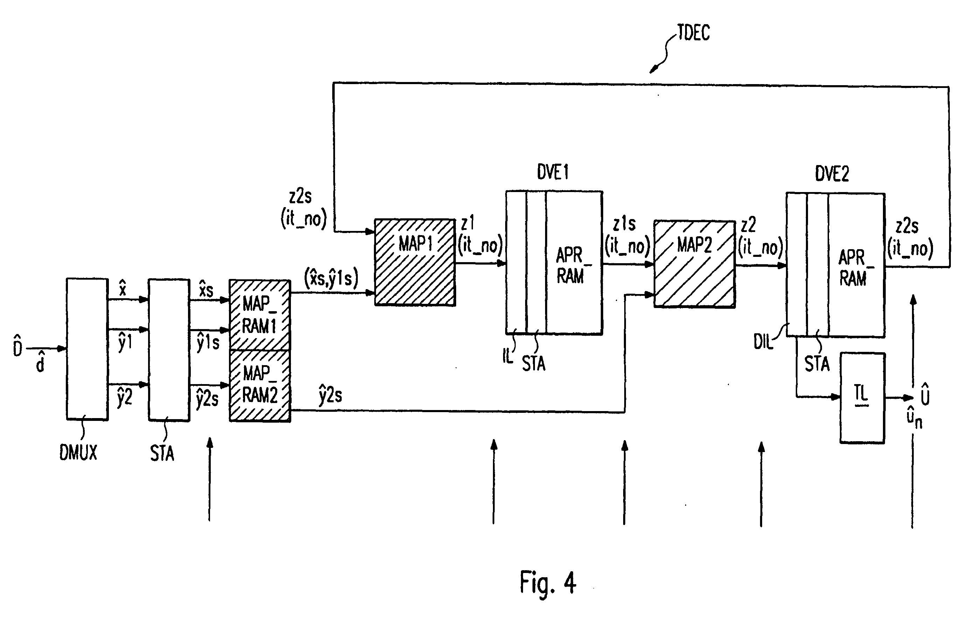

Fig. 4 zeigt ein Blockschaltbild zur Erläuterung der Arbeitsweise eines Ausführungsbeispiels eines erfindungsgemäßen Turbo-Decodierers TDEC.

Der Turbo-Decodierer TDEC umfaßt einen Demultiplexer DMUX, eine Statistik-Stufe STA, einen ersten und zweiten Speicher mit wahlfreiem Zugriff MAP_RAM1, MAP_RAM2, einen ersten und zweiten MAP-Symbolschätzer MAP1 und MAP2, eine erste und zweite Datenverarbeitungseinheit DVE1, DVE2 sowie eine Entscheidungslogik (Schwellenwertentscheider) TL.

Die erste Datenverarbeitungseinheit DVE1 umfaßt einen Turbo-Verschachteler IL, eine Statistik-Stufe STA und einen Datenspeicher APR_RAM. Die zweite Datenverarbeitungseinheit DVE2 umfaßt einen Entschachteler DIL, ebenfalls eine Statistik-Stufe STA und ebenfalls einen Datenspeicher APR_RAM.

Die von dem Demodulator DMOD dem Turbo-Decodierer TDEC zugeführte entzerrte Datenfolge $\hat{D} = (\hat{x}_1, \hat{y1}_1, \hat{x}_2, \hat{y2}_2, \hat{x}_3, \hat{y1}_3, \hat{x}_4, \hat{y2}_4, .., \hat{x}_N, \hat{y2}_N)$ wird von dem eingangsseitig vorgesehenen Demultiplexer DMUX in die entzerrte systematische Datenfolge X (detektierte Version der Eingabesignalfolge U (= X)) und die beiden entzerrten Redundanz-Teilfolgen Y1 und Y2 (detektierte Versionen der Redundanz-Teilfolgen Y1 und Y2) aufgespalten. Mit $\hat{x}_n, \hat{y1}_n, \hat{y2}_n$ (n = 1, 2, .., N) werden die entzerrten (geschätzten) Versionen der senderseitig auftretenden Datensymbole $x_n, y1_n, y2_n$ bezeichnet. (In der Zeichnung sind die Indizes n der jeweiligen Folgenelemente aus Gründen der Übersichtlichkeit weggelassen.)

Die Datensymbole $\hat{x}_n$ (systematische Information) und $\hat{y1}_n, \hat{y2}_n$ (Redundanz-Information) werden der Statistik-Stufe STA zugeführt. Basierend auf der Kenntnis des momentanen Zustands des Übertragungskanals werden dort die statistischen Datenwerte $xs_n, y1s_n, y2s_n$ gemäß der folgenden Gleichungen berechnet.

$$\hat{x}s_n \;=\; \hat{x}_n \,\cdot\, \mu_{\hat{x}n} \,/\, \sigma^2_{\hat{x}n}$$

$$\hat{y}1s_n \; = \; \hat{y}1_n \; \cdot \; \mu_{\hat{y}1n} \; / \; \sigma^2_{\hat{y}1n}$$

$$\hat{y}2s_n \; = \; \hat{y}2_n \; \cdot \; \mu_{\hat{y}2n} \; / \; \sigma^2_{\hat{y}2n} \tag{1}$$

Dabei bezeichnen $\mu_{\hat{x}n}$ , $\mu_{\hat{y}1n}$ , $\mu_{\hat{y}2n}$ die Mittelwerte und $\sigma^2_{\hat{x}n}$, $\sigma^2_{\hat{y}1n}$ , $\sigma^2_{\hat{y}2n}$ die Varianzen des weißen Rauschens bezüglich der zugehörigen Signalanteile.

Die statistischen Datensymbolwerte $\hat{x}s_n$ und $\hat{y}1s_n$ werden in dem Datenspeicher MAP_RAM1 abgelegt und die statistischen Datenwerte $y2s_n$ werden in dem Datenspeicher MAP_RAM2 abgelegt. Die Speichergrößen von MAP_RAM1 und MAP_RAM2 sind jeweils so bemessen, daß die statistischen Datenwerte eines gesamten Blocks (z. B. N = 5120) Platz finden.

Auf der Grundlage der für einen Datenblock repräsentativen systematischen Information $\hat{x}s_n$ und Redundanz-Information $y1s_n$ und $y2s_n$ erfolgt eine iterative Turbo-Decodierung: Die Iterationsschleife wird durch die Einheiten MAP1, DVE1, MAP2, DVE2 und die Rückführung von Rückkoppel-Information $z2s_n$ von DVE2 zu MAP1 gebildet.

Genauer gesagt berechnet der erste MAP-Symbolschätzer MAP1 auf der Basis der Eingangs-Datenwerte $\hat{x}s_n$ und $y1s_n$ und einer Anfangs-Rückkoppel-Information $z2s_n$(it no = 0) in einem ersten Iterationsschritt (it_no = 1) eine erste Folge von wertekontinuierlicher logarithmischer erster Zuverlässigkeitsinformation $z1_n$(it_no = 1). Diese erste Iterationsfolge logarithmischer Zuverlässigkeitsinformation wird in dem Turbo-Verschachteler IL verschachtelt und in der Statistik-Stufe STA statistisch aufbereitet. Die statistische Aufbereitung erfolgt nach der Gleichung

$$Z1s_n = Z1_n \cdot \mu_{z1n} / \sigma^2_{z1n} \tag{2}$$

Dabei bezeichnet $\mu_{z1n}$ den Mittelwert und $\sigma^2_{z1n}$ die Varianz des weißen Rauschens der ersten Zuverlässigkeitsinformation $z1_n$.

Zur Durchführung der genannten Prozeduren (Verschachtelung und statistische Aufbereitung) werden die Folgewerte $z1s_n$(it_no = 1) in dem Datenspeicher mit wahlfreiem Zugriff APR_RAM der ersten Datenverarbeitungseinheit DVE1 zwischengespeichert.

Die in der ersten Datenverarbeitungseinheit DVE1 bei der ersten Iteration erzeugten Datenwerte $z1s_n$(it_no = 1) der verschachtelten Folge von erster Zuverlässigkeitsinformation (erste Iteration) werden dem zweiten MAP-Symbolschätzer MAP2 zugeleitet. Dieser berechnet aus diesen Datenwerten und der Folge $y2s_n$ (für alle Iterationsdurchgänge identisch) eine Folge von zweiter logarithmischer Zuverlässigkeitsinformation $z2_n$(it_no = 1). Die einzelnen Werte der Folgen von erster und zweiter Zuverlässigkeitsinformation sind logarithmische a-Posteriori-Wahrscheinlichkeitsverhältnisse, sog. LLRs (Log-Likelihood Ratios).

Die Folge der zweiten Zuverlässigkeitsinformation $z2_n$(it_no = 1) wird dem Turbo-Entschachteler DIL und der Statistik-Stufe STA der zweiten Datenverarbeitungseinheit DVE2 zugeleitet und dort entschachtelt und statistisch aufbereitet. Die statistische Aufbereitung erfolgt nach der Gleichung

$$z2s_n = z2_n \cdot \mu_{z2n} / \alpha^2_{z2n} \tag{3}$$

Dabei bezeichnet $\mu_{z2n}$ den Mittelwert und $\alpha^2_{z2n}$ die Varianz des weißen Rauschens der zweiten Zuverlässigkeitsinformation $z2_n$.

Der Datenspeicher mit wahlfreiem Zugriff APR_RAM dient wiederum der Zwischenspeicherung der in der beschriebenen Weise erzeugten Datenwerte $z2s_n$(it_no = 1). Gemäß Fig. 4 stehen sie als Rückkoppel-Information dem ersten Symbolschätzer MAP1 während des nächsten Iterationsdurchlaufs (it_no = 2) zur Verfügung.

Nach einer vorgegebenen Anzahl von beispielsweise 5 Iterationsdurchläufen werden die am Ausgang des Turbo-Entschachtelers DIL der zweiten Datenverarbeitungseinheit DVE2 erzeugten Datenwerte $z2_n$(it_no = 5) (entschachtelt) einem Schwellenwertentscheider TL zugeleitet. Der Schwellenwertentscheider TL bestimmt für jedes Element der angegebenen Datenfolge mit einem Wert $\leq 0$ ein rekonstruiertes Datensymbol $\hat{u}_n = 0$ und für jedes Element der genannten Datenfolge mit einem Wert > 0 ein rekonstruiertes Datensymbol $\hat{u}_n = 1$.

Anhand der nachfolgenden Figuren wird deutlich, daß die in Fig. 4 mehrfach dargestellten Statistik-Stufen STA, die ersten und zweiten Symbolschätzer MAP1, MAP2 und die Datenspeicher mit wahlfreiem Zugriff APR_RAM jeweils in Form ein und derselben Hardware-Struktur realisiert sein können. Die im unteren Bereich der Fig. 4 eingezeichneten Pfeile kennzeichnen in diesem Fall die mittels einer bidirektionalen Schnittstelle realisierten Datenübergabeorte, an welchen ein Datentransfer zwischen einem Symbolschätzer (enthält MAP1/2 und die zugeordneten Speicher MAP_RAM1/2, schraffiert gezeichnet) und einen digitalen Signalprozessor (enthält DVE1/2, DMUX, STA, TL, ohne Schraffur) bewerkstelligt wird.

Es sei erwähnt, daß insbesondere die Statistikstufe STA auch in Hardware ausgeführt und in dem Symbolschätzer integriert sein kann.

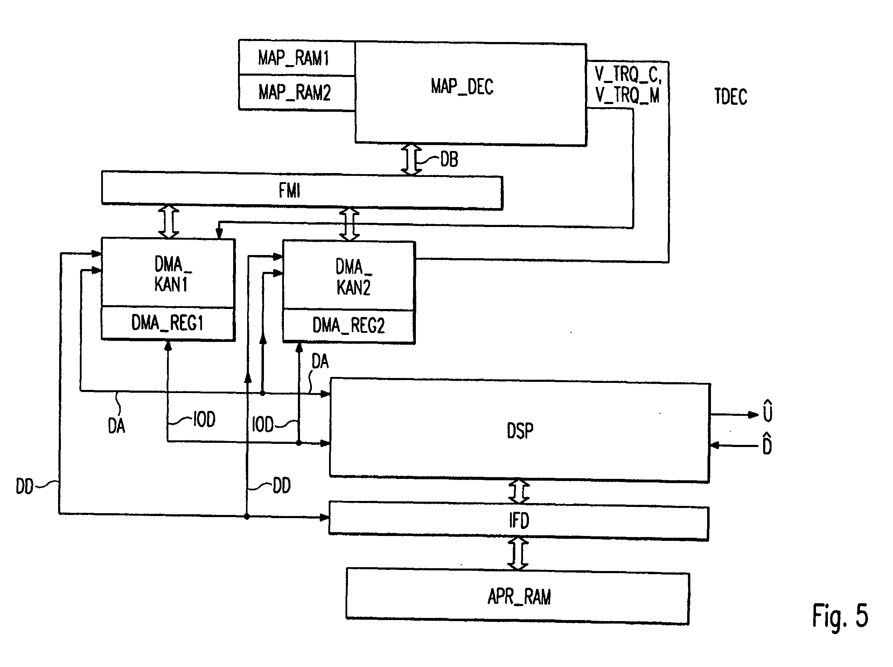

Fig. 5 zeigt ein Blockschaltbild des bereits anhand Fig. 4 beschriebenen Turbo-Decodierers TDEC.

Der Turbo-Decodierer TDEC umfaßt einen MAP-Decodierer MAP_DEC, welcher den beiden Symbolschätzern MAP1/2 in Fig. 4 entspricht und mit den beiden MAP-Datenspeichern MAP_RAM1 und MAP_RAM2 in Verbindung steht. Der MAP-DecodiererMAP_DEC ist über einen bidirektionalen Datenbus DB und eine FMI-(flexible memory interface-)Schnittstelle FMI mit zwei programmierbaren DMA-(direkter Speicherzugriff: direct memory access-)Kanälen DMA_KAN1 und DMA_KAN2 verbunden. Die "Lage" dieser FMI-Schnittstelle FMI mit zugeordneten DMA-Kanälen DMA_KAN1 und DMA_KAN2 im Turbo-Decodierablauf ist wie bereits erwähnt in der Fig. 4 durch die Pfeile angezeigt.

Die programmierbaren DMA-Kanäle DMA_KAN1/2 umfassen jeweils interne DMA-Register DMA_REG1, DMA_REG2. Die internen DMA-Register DMA_REG1/2 stehen über jeweilige Programmierleitungen IOD mit einem digitalen Signalprozessor DSP in bidirektionaler Datenaustauschverbindung.

Der DSP hat über Datenleitungen und eine interne DSP-Schnittstelle IFD Zugriff auf den Datenspeicher APR_RAM. Ferner stehen der DSP und die DSP-Schnittstelle IFD über eine bidirektionale Busstruktur bestehend aus einem Datenbus DD und einem Adressbus DA mit den DMA-Kanälen DMA_KAN1/2 in Datenaustauschverbindung.

Der DSP führt durch Abarbeitung einer herstellerseitig programmierten Software (Firmware) unter Zwischenspeicherung von Daten im Datenspeicher APR_RAM die statistischen Berechnungen sowie die Ver- und Entschachtelungsprozeduren (siehe Fig. 4) und gegebenenfalls auch die von den Einheiten DMUX und TL ausgeführten Datenverarbeitungsschritte durch.

Die Datenübermittlung über die DMA-Kanäle DMA_KAN1/2 sowie die FMI-Schnittstelle FMI zu dem MAP-Decodierer MAP_DEC wird über zwei Datenanforderungs-Steuersignale V_TRQ_M (Anforderung des Datentransfers über den ersten DMA-Kanal DMA_KAN1) und V_TRQ_C (Anforderung des Datentransfers über den zweiten DMA-Kanal DMA_KAN2) initiiert.

Über den ersten DMA-Kanal DMA_KAN1 werden die Eingabedaten für die erste und die zweite Symbolschätzung (MAP1- und MAP2-Modus) übertragen. Für die erste Symbolschätzung sind dies einerseits die statistischen Datenwerte der systematischen Information $\hat{x}s_n$ und die statistischen Datenwerte der ersten Redundanz-Information $\hat{y}1s_n$, welche lediglich einmal am Anfang eines Block-Decodierablaufes übertragen werden müssen, und andererseits sind dies die statistisch aufbereiteten Datenwerte $z2s_n(it\_no)$ der Rückkoppel-Information, die in jedem Iterationsdurchlauf der Turbo-Decodierung übertragen werden.

Ein bei einer Wortbreite von 16 Bit beispielsweise verwendetes Datenformat der Eingabewerte für den ersten Symbolschätzer MAP1 ist in den beiden Tabellen 1 und 2 dargestellt.

Tabelle 1

| (Datenübergabe an MAP1, einmal pro Block) | | | |
|---|---|---|---|
| Bits 0-3 | Bits 4-7 | Bits 8-11 | Bits 12-15 |
| $\hat{x}s_1$ | | $\hat{y}1s_1$ | |
| $\hat{x}s_2$ | | $\hat{y}1s_2$ | |
| $\hat{x}s_3$ | | $\hat{y}1s_3$ | |
| ... | | ... | |
| ... | | ... | |
| $\hat{x}s_N$ | | $\hat{y}1s_N$ | |

Tabelle 2

| (Datenübergabe an MAP1, bei jedem Iterationsdurchlauf) | | | |
|---|---|---|---|
| Bits 0-3 | Bits 4-7 | (Bits 8-11 | Bits 12-15 |
| $z2s_1 (it\_no=1-5)$ | | | |
| $z2s_2 (it\_no=1-5)$ | | | |
| $z2S_3 (it\_no=1-5)$ | | | |

Tabelle 2   (fortgesetzt)

| (Datenübergabe an MAP1, bei jedem Iterationsdurchlauf) | | | |
|---|---|---|---|
| Bits 0-3 | Bits 4-7 | (Bits 8-11 | Bits 12-15 |
| | | | |
| ... | | | |
| $z2s_N$ (it_no=1-5) | | | |

Für die zweite Symbolschätzung (MAP2-Modus) werden dem MAP-Decodierer MAP_DEC ebenfalls über den ersten DMA-Kanal DMA_KAN1, die bidirektionale FMI-Schnittstelle FMI und den Datenbus DB die statistischen Datenwerte der zweiten Redundanz-Information $y2s_n$ und - bei jedem Iterationsdurchlauf - die statistisch aufbereiteten Datenwerte der ersten Zuverlässigkeitsinformation $z1s_n$(it_no) zugeleitet. Ein mögliches Datenformat der Datenübertragung ist in den Tabellen 3 und 4 dargestellt:

Tabelle 3

| (Datenübergabe für die zweite Symbolschätzung, einmal pro Block) | | | |
|---|---|---|---|
| Bits 0-3 | Bits 4-7 | Bits 8-11 | Bits 12-15 |
| $\hat{y2s_1}$ | | | |
| $\hat{y2s_2}$ | | | |
| $\hat{y2s_3}$ | | | |
| ... | | | |
| ... | | | |
| $\hat{y2s_N}$ | | | |

Tabelle 4

| (Datenübergabe an MAP2, bei jedem Iterationsdurchlauf) | | | |
|---|---|---|---|
| Bits 0-3 | Bits 4-7 | Bits 8-11 | Bits 12-15 |
| $z1s_1$ (it_no=1-5) | | | |
| $z1s_2$ (it_no=1-5) | | | |
| $z1s_3$ (it_no=1-5) | | | |
| | | | |
| | | | |
| $z1s_N$ (it_no=1-5) | | | |

Der zweite DMA-Kanal DMA_KAN2 dient der Übertragung der Ergebniswerte (Ausgabedaten) $z1_n$ und $z2_n$ der Symbolschätzer MAP1 bzw. MAP2 zum DSP.

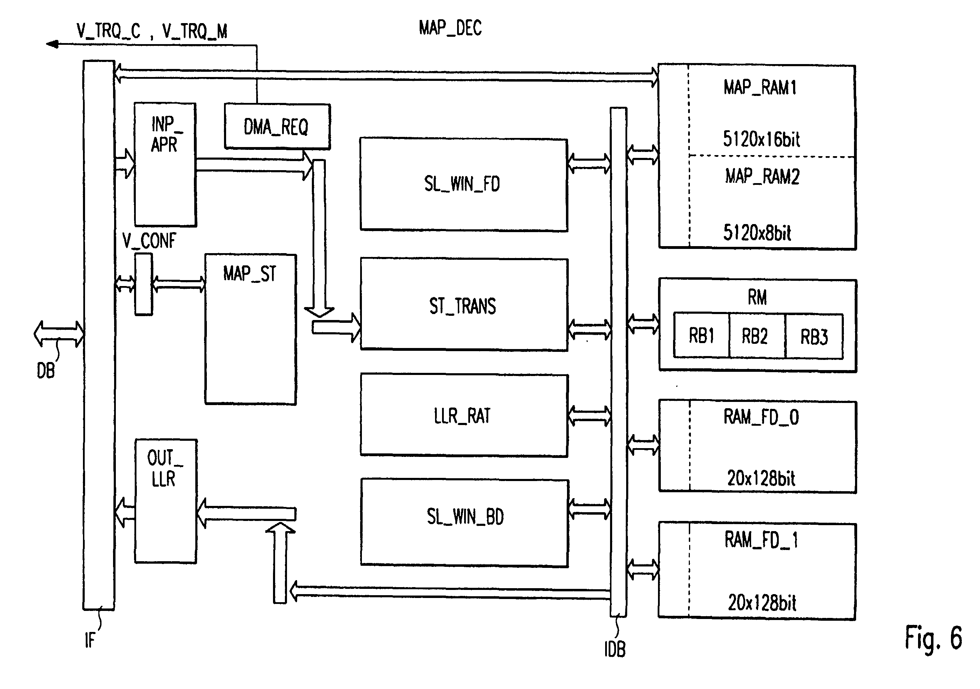

Fig. 6 zeigt ein Blockschaltbild des MAP-Decodierers MAP_DEC.

Die über den Datenbus DB übertragenen Daten werden einer internen Schnittstelle IF übergeben.

Neben der internen Schnittstelle IF und den beiden MAP-Datenspeichern MAP_RAM1 (z.B. N x 16 Bit) und MAP_RAM2 (z.B. N x 8 Bit) umfaßt der MAP-Decodierer MAP_DEC einen Eingabedatenspeicher INP_APR, einen Ausgabedatenspeicher OUT_LLR, ein Konfigurations-Register V_CONF, eine DMA-Anforderungseinheit DMA_REQ zur Erzeugung der Anforderungs-Steuersignale V_TRQ_C und V_TRQ_M und ein Modul zum Erzeugen von standardspezifischer Code-Information (Trellis-Information) MAP_ST. Ferner umfaßt der MAP-Decodierer MAP_DEC eine Steuereinheit ST_TRANS zur Steuerung der Berechnung von Übergangs-Metrikwerten, eine Steuereinheit SL_WIN_FD zur Steuerung der Berechnung von Vorwärtsrekursions-Metrikwerten, eine Steuereinheit SL_WIN_BD zur Steuerung der Berechnung von Rückwärtsrekursions-Metrikwerten und eine Steuereinheit LLR_RAT zur Steuerung der Berechnung von Werten der ersten und zweiten Zuverlässigkeitsinformation $z1_n$(it_no) bzw. $z2_n$(it_no). Die vier Steuereinheiten stehen über einen internen Datenbus IDB mit einem drei Hardware-Rechenbausteine RB1, RB2, RB3 umfassenden Rechenmittel RM in Datenaustauschverbindung. Ferner kann über den internen Datenbus IDB auf zwei Datenspeicher für Vorwärtsrekursions-Metrikwerte, nämlich RAM_FD_0 und RAM_FD_1, beide z.B. 20 x 128 Bit groß, zugegriffen werden. RAM_FD_0 beinhaltet Vorwärtsrekursions-Metrikwerte, die aufgrund eines Übergangs mit einem Eingangsbit von 0 erzeugt werden. RAM_FD_1 beinhaltet Vorwärtsrekursions-Metrikwerte, die aufgrund eines Übergangs mit einem Eingangsbit von 1 erzeugt werden.

Die Funktionsweise des in Fig. 6 dargestellten MAP-Decodierers ist wie folgt:

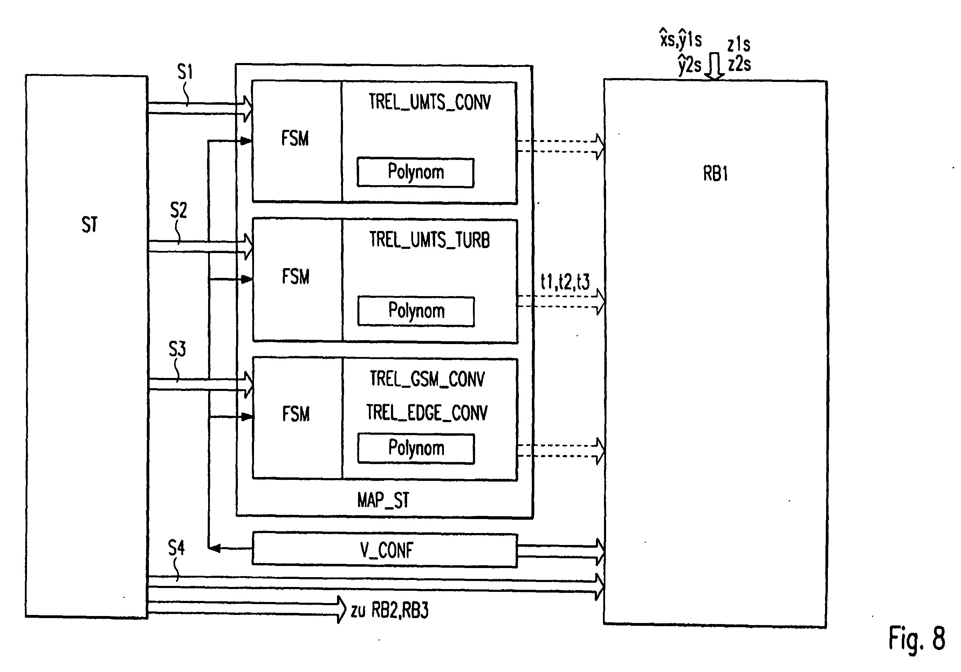

Im Rahmen eines Initialisierungsvorgangs wird dem MAP-Decodierer MAP_DEC über den Datenbus DB zunächst mitgeteilt, welcher Code der senderseitigen Codierung des zu übertragenden Datensignals zugrundeliegt. Unter den verfügbaren Codes ist erfindungsgemäß zumindest ein Turbo-Code. Entsprechend dem zugrundliegenden Code werden in dem Modul MAP_ST codespezifische Eingangsdatenwerte für den ersten Rechenbaustein RB1 erzeugt. Dies wird in Verbindung mit Fig. 8 noch näher erläutert.

Zur Decodierung eines gesamten Datenblocks werden zunächst die Datenwerte $\hat{xs}_n$, $\hat{y1s}_n$ und $\hat{y2s}_n$ der (im DSP bereits statistisch aufbereiteten) systematischen Information und der ersten und zweiten Redundanz-Information für einen Datenblock (n = 1, .., N) in die Datenspeicher MAP_RAM1/2 geladen.

Zu Beginn der Decodierung arbeitet der MAP-Decodierer MAP_DEC im MAP1-Modus. Auf der Basis des Speicherinhalts von MAP_RAM1 und der Anfangs-Rückkoppel-Information $z2s_n(it\_no = 0)$ werden unter der Steuerung der Steuereinheit ST_TRANS in dem ersten Rechenbaustein RB1 Übergangs-Metrikwerte, unter der Steuerung der Steuereinheiten SL_WIN_FD und SL_WIN_BD in dem zweiten Rechenbaustein RB2 Vorwärts- und Rückwärtsrekursions-Metrikwerte und unter der Steuerung der Steuereinheit LLR_RAT mittels des dritten Rechenbausteins RB3 die logarithmischen Werte der ersten Zuverlässigkeitsinformation bezüglich des ersten Iterationsdurchlaufs $z1_n(it\_no = 1)$ erzeugt. Diese Werte werden über den Ausgabedatenspeicher OUT_LLR, die interne Schnittstelle IF und den Datenbus DB dem DSP zugeleitet.

Wie bereits anhand von Fig. 4 beschrieben, werden die von dem DSP erzeugten (verschachtelten und statistisch aufbereiteten) Datenwerte $z1s_n(it\_no = 1)$ nach Anforderung mittels des Steuersignals V_TRQ_C zum MAP-Decodierer MAP_DEC zurückgegeben und zunächst in dem Eingabedatenspeicher INP_APR zwischengespeichert.

Der MAP-Decodierer MAP_DEC arbeitet nun im MAP2-Modus, d.h., daß die vorstehend beschriebene Berechnungsprozedur jetzt auf der Grundlage der im zweiten MAP-Datenspeicher MAP_RAM2 gespeicherten Datenwerte $(\hat{y2s}_n)$ und den in dem Eingabedatenspeicher INP_APR zwischengespeicherten Werte durchgeführt wird. Die Ausgabe der Werte der zweiten Zuverlässigkeitsinformation $z2_n(it\_no = 1)$ erfolgt wiederum über den Ausgabedatenspeicher OUT_LLR.

Nachfolgend wird die Berechnung der LLRs mittels Vorwärtsund Rückwärtsrekursion anhand der Berechnung der ersten Zuverlässigkeitsinformation $z1_n$ näher erläutert.

Jeder Wert $z1_n$ ist ein wertekontinuierliches, logarithmisches Wahrscheinlichkeitsverhältnis für das uncodierte Datensymbol $u_n$ der Eingabesignalfolge U,

$$z1_n = \ln\left\{\frac{P\left(u_n = 1 \middle| \hat{X}, \hat{Y}1, Z2\right)}{P\left(u_n = 0 \middle| \hat{X}, \hat{Y}1, Z2\right)}\right\} \qquad (4)$$

Mit P $(u_n = 1 | \hat{X}, \hat{Y}1, Z2)$ bzw. P $(u_n = 0 | \hat{X}, \hat{Y}1, Z2)$ werden die bedingten Wahrscheinlichkeiten dafür bezeichnet, daß das Datensymbol $u_n$ gleich 1 bzw. gleich 0 ist unter der Bedingung, daß die Folgen X, Y1, Z2 beobachtet werden. Diese bedingten Wahrscheinlichkeiten sind "Wahrscheinlichkeiten a-Posteriori", da von einem eingetretenen Ereignis (den "gemessenen" Folgen X, Y1, Z2) auf die Wahrscheinlichkeiten der diesem Ereignis zugrundeliegenden, uncodierten Datensymbole $u_1$ bis $u_N$ rückgeschlossen wird.

Der Zustand des senderseitigen Faltungscodierers RSC1 zum Zeitpunkt n (d.h. beim Eingabe-Datensymbol $u_n$) wird mit $S_n$ bezeichnet.

Die bedingten a-Posteriori-Wahrscheinlichkeiten in der Gleichung (4) lassen sich als Summen von Einzel-a-Posteriori-Wahrscheinlichkeiten über die $M = 2^{L-1}$ möglichen Zustände $S_n = 0, 1, .., M-1$ des Codierers RSC1 ausdrücken, wobei mit L die Rückgriffstiefe des erzeugten Turbo-Codes bezeichnet wird:

$$zl_n = \ln\left\{\frac{\sum_{m=0}^{M-1} P\left(u_n = 1, S_n = m | \hat{X}, \hat{Y}1, Z2\right)}{\sum_{m=0}^{M-1} P\left(u_n = 0, S_n = m | \hat{X}, \hat{Y}1, Z2\right)}\right\} \tag{5}$$

Die Einzelwahrscheinlichkeiten können in der folgenden Form geschrieben werden

$$P\left(u_n = i, S_n = m | \hat{X}, \hat{Y}1, Z2\right) = \alpha_n^i(m) \cdot \beta_n(m) \qquad i = 0, 1$$

mit

$$\alpha_n^i(m) = P\left(u_n = i, S_n = m | R_1^N\right)$$

$$\beta_n(m) = \frac{P\left(R_{n+1}^N | S_n = m\right)}{P\left(R_{n+1}^N | R_1^N\right)} \tag{6}$$

wobei zur Vereinfachung der Schreibweise die Folge

$$R_\nu^\mu = (R_\nu, \dots, R_\mu), \qquad 1 \le \nu < \mu \le N \tag{7}$$

bestehend aus den Wertetripeln $R_n = (\hat{x}_n, \hat{y}1_n, z2_n)$ von systematischer Information, Redundanz-Information und Rückkoppel-Information definiert wird.

Der Ausdrücke $\alpha_n^i(m)$ und $\beta_n(m)$ werden als Vorwärtsrekursions und Rückwärtsrekursions-Metriken bezeichnet, da sie unter der Voraussetzung, daß die Übergangs-Metrikwerte $\gamma_n^i(R_n, m', m)$ bekannt sind, rekursiv ermittelt werden können. Die Übergangs-Metrikwerte $\gamma_n^i(R_n, m', m)$ sind die Übergangswahrscheinlichkeiten von einem ersten Zustand $S_{n-1} = m'$ in einen zweiten Zustand $S_n = m$ des Codierers RSC1 im Trellis-Diagramm, d.h.

$$\gamma_n^i(R_n, m', m) = P\left(u_n = i, S_n = m, R_n | S_{n-1} = m'\right) \tag{8}$$

Eine detaillierte Beschreibung der Rekursionen (bei Verwendung einer optimalen MAP-Symbolschätzung) ist in dem Kapitel E.3.3 "Rekursive MAP-Symbolschätzung" des genannten Buchs von P. Jung auf den Seiten 353 bis 361 angegeben. Die Rekursionen laufen herkömmlicherweise über den gesamten Block, d.h. die Vorwärtsrekursion beginnt beim Zeitpunkt n = 1 (erstes Bit der Folgen X, Y1, Z2: MAP1, bzw. der Folgen Y2, Z1: MAP2) und endet im Zeitpunkt n = N (letztes Bit der Folgen X, Y1, Z2: MAP1, bzw. der Folgen Y2, Z1: MAP2), und die Rückwärtsrekursion beginnt beim Zeitpunkt n = N und endet im Zeitpunkt n = 1.

Demgegenüber werden bei dem hier beschriebenen Ausführungsbeispiel des MAP-Decodierers MAP_DEC zur Berechnung der LLRs $z1_n$ und $z2_n$ pro Datenblock vorzugsweise mehrere Rückwärtsund vorwärtsrekursionen durchgeführt, die sich jeweils (nur) über Teilintervalle des Datenblocks erstrecken.

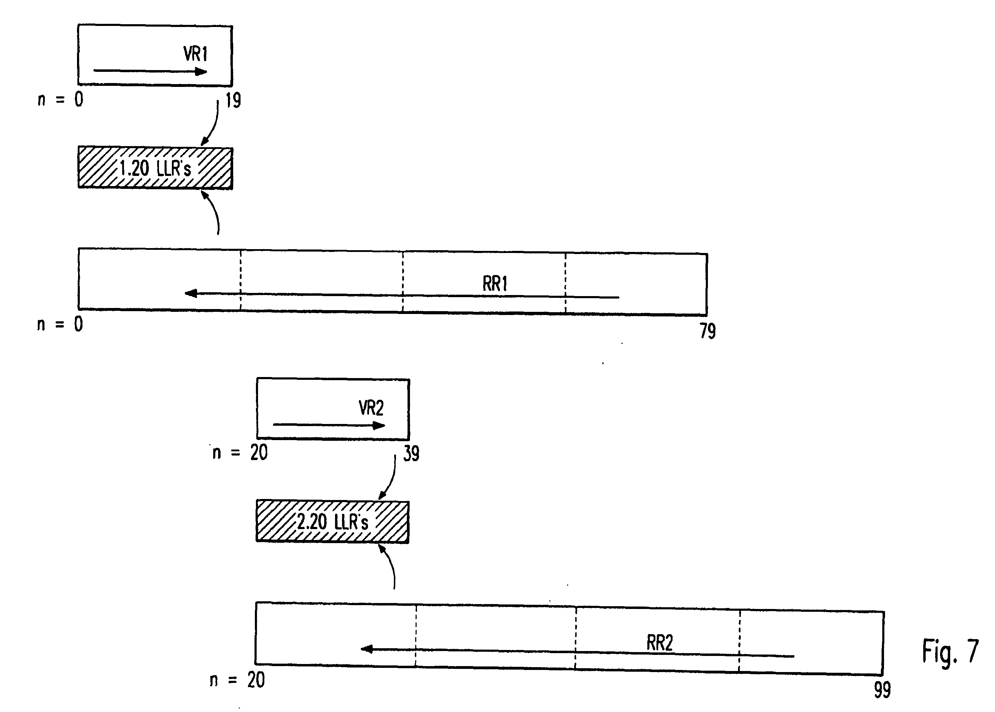

In der Steuereinheit SL_WIN_FD wird eine Intervalllänge (Fenstergröße) für die Vorwärtsrekursionen von beispielsweise DV = 20 festgelegt. Beginnend bei n = 0 werden in einem ersten Vorwärtsrekursionslauf VR1 (siehe Fig. 7) in dem zweiten Rechenbaustein RB2 zunächst z.B. die ersten 20 Vorwärtsrekursions-Metrikwerte Werte $\alpha_0^i(m)$, .., $\alpha_{19}^i(m)$ bestimmt und wie bereits erwähnt in den Vorwärtsrekursions-Speicherbereichen RAM_FD_0 (für i = 0) bzw. RAM_FD_1 (für i = 1) zwischengespeichert.

Für die zugehörige erste Rückwärtsrekursion RR1 sei in SL_WIN_BD eine Intervalllänge für Rückwärtsrekursionen (Fenstergröße) von beispielsweise DR = 80 festgelegt. (vorzugsweise bestimmt sich die Länge des Rückwärtsrekursionsfensters gemäß der Beziehung DR = L x DV.) Somit beginnt die erste Rückwärtsrekursion unter der Steuerung von SL_WIN_BD bei n = 79 und läuft bis n = 0. Es werden dabei in dem zweiten Rechenbaustein RB2 die entsprechenden Rückwärtsrekursions-Metrikwerte $\beta_n(m)$ berechnet.

Zur Berechnung der LLRs im Datenblocksegment n = 0, 1, .., 19 werden sämtliche 20 berechneten Werte für $\alpha_n^i(m)$ und die letzten zwanzig berechneten Werte für $\beta_n(m)$ herangezogen. Die Berechnung erfolgt wie bereits erwähnt im dritten Rechenbaustein RB3 unter der Steuerung von LLR_RAT. Eine Speicherung der Rückwärtsrekursions-Metrikwerte ist dabei nicht erforderlich, da sie zur Berechnung der LLRs sofort weiterverarbeitet werden können.

Nach der Berechnung der ersten 20 LLRs werden die beiden Rekursionsfenster jeweils um 20 Werte "nach rechts" verschoben.

Die zweite Vorwärtsrekursion VR2 beginnt demzufolge bei n = 20 und läuft bis n = 39. Bei der Zwischenspeicherung der Werte $\alpha_{20}^i(m)$, .., $\alpha_{39}^i(m)$ können die bei der ersten Vorwärtsrekursion VR1 gewonnenen Werte in RAM_FD_0 bzw. RAM_FD_1 überschrieben werden. Die zugehörige zweite Rückwärtsrekursion RR2 beginnt bei n = 99 und läuft bis n = 20 zurück. Die letzten 20 berechneten Werte für $\beta_n(m)$ können wiederum ohne Abspeicherung direkt an den Rechenbaustein RB3 übergeben werden. Zur Berechnung der LLRs im Blocksegment n = 20, 21, .., 39 werden auch wieder sämtliche 20 berechneten Werte für $\alpha_n^i(m)$ und die letzten zwanzig berechneten Werte für $\beta_n(m)$ herangezogen.

Diese segmentweise Bestimmung der LLRs mit gleitenden Vorwärts- und Rückwärtsrekursionsfenstern wird, von LLR_RAT gesteuert, in der beschriebenen Weise fortgeführt, bis sämtliche LLRs des Datenblockes berechnet sind. Günstig ist der geringe Speicherplatzbedarf für RAM_FD_0 und RAM_FD_1 sowie die Tatsache, daß die Rückwärtsrekursions-Metrikwerte nicht abgespeichert werden müssen.

Nachfolgend wird die näherungsweise Berechnung der übergangs-Metrikwerte, der Vorwärts- und Rückwärtsrekursions-Metrikwerte und der LLR's in dem Rechenmittel RM anhand der Fig. 8, 9a-d und 10 näher erläutert.

Das Modul MAP_ST umfaßt drei Untermodule TREL_UMTS_CONV, TREL_UMTS_TURB, und TREL_GSM_CONV/TREL_EDGE_CONV. Alle Untermodule enthalten einen eigenen Zustandsgenerator FSM.

Eine Steuereinheit ST dient zur zeitlichen Steuerung und Koordination der Zustandsgeneratoren FSM und der Rechenbausteine RB1, RB2, RB3. Hierzu steht die Steuereinheit ST über Steuerdatenleitungen S1, S2 und S3 mit den Zustandsgeneratoren FSM der Untermodule TREL_UMTS_CONV, TREL_UMTS_TURB, TREL_GSM_CONV/ TREL_EDGE_CONV in Verbindung und steuert ferner über eine weitere Steuerdatenleitung S4 den ersten Rechenbaustein RB1. Weitere Steuerdatenleitungen führen zu den anderen Rechenbausteinen RB2, RB3.

Jedes Untermodul von MAP_ST berechnet theoretische Information (wird auch als sogenannte Trellis-Information bezeichnet), welche für einen bestimmten Code charakteristisch ist. Die Berechnung der theoretischen Information erfolgt jeweils auf der Grundlage eines Code-spezifischen Polynoms. Den in den Untermodulen TREL_GSM_CONV bzw. TREL_EDGE_CONV berechneten Werten der theoretischen Information liegen die GSM-(Global System for Mobile Communication-) und EDGE-(enhanced data services for GSM evolution-)Standards zugrunde. Den von dem Untermodul TREL UMTS TURB berechneten theoretischen Werten t1, t2, t3 liegt der UMTS-(Universal Mobile Telecommunications Systems-)Standard für Turbo-Decodierung zugrunde.

Im folgenden wird nur der Fall der Anwahl des Untermoduls TREL_UMTS_TURB durch V_CONF betrachtet.

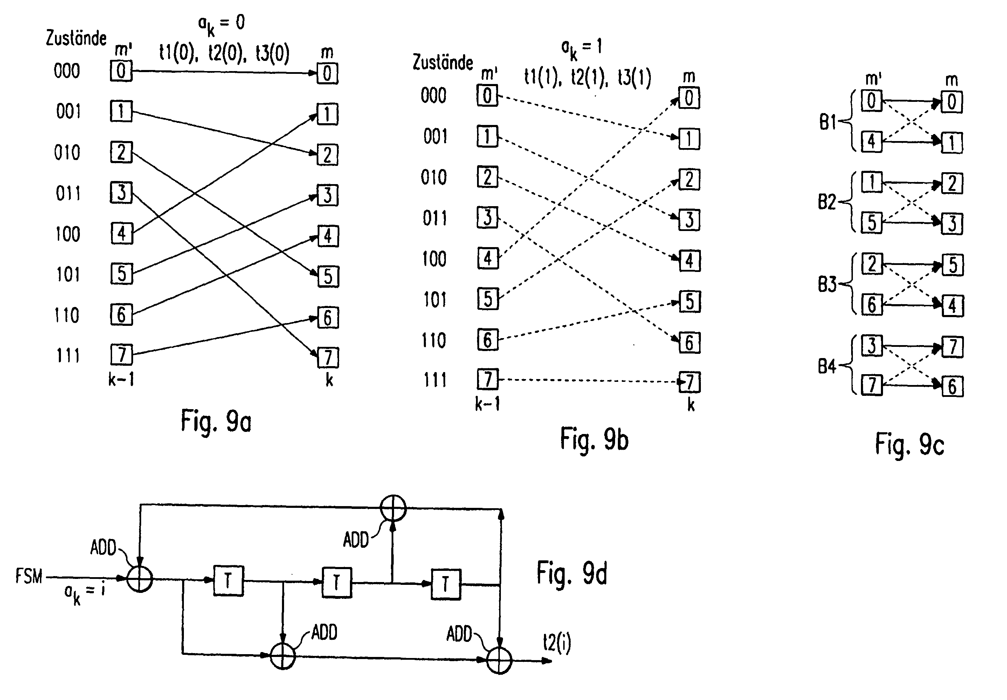

In UMTS ist ein Turbo-Code der Rückgriffstiefe L = 4 vorgesehen. Folglich kann das Schieberegister des Faltungscodierers RSC1 im Turbo-Codierer (siehe Fig. 3) genau 8 Zustände einnehmen, nämlich 000, 001, 010, ... usw. In den Fig. 9a und 9b ist jeder dieser 8 möglichen Zustände durch ein mit den Index-Zahlen m = 0 bis 7 durchnummeriertes Kästchen dargestellt.

Fig. 9a zeigt die Zustandsübergänge m' zu m, die auftreten, wenn der zunächst (bei Schritt k-1) in einem (beliebigen) Ausgangszustand befindliche Turbo-Codierer durch Hinzufügen eines Eingabebits $a_k$ des Wertes 0 (d.h. i = 0) in einen darauffolgenden Zustand (bei Schritt k) gebracht wird. Ein entsprechendes Schaubild, das die bei Hinzufügen eines Eingabebits $a_k$ des Wertes 1 (d.h. i = 1) auftretenden Zustandsübergänge darstellt, ist in Fig. 9b gezeigt.

Für jeden möglichen Zustandsübergang (von k-1 nach k) werden drei theoretische Werte t1(i), t2(i), t3(i) berechnet.

Die Werte t1(i) und t3(i) sind identisch mit dem hinzugefügten Eingabebit $a_k$ (d.h. t1(i) = t3(i) = i). Der Wert t2 wird durch das Code-spezifische Polynom berechnet.

Eine mögliche Berechnungsschaltung für den Wert t2 aus $a_k$ ist in Fig. 9d dargestellt. Die Berechnungsschaltung umfaßt ein aus drei Speicherzellen T bestehendes Schieberegister und vier Addierer ADD, die in der dargestellten Weise in der Schaltung angeordnet sind. Das Schieberegister wird von dem Zustandsgenerator FSM mit einen Ausgangszustand (z.B. m' = 0, d.h. (000)) belegt und mit einem Eingabebit $a_k$ versorgt. Bei Hinzufügen des Eingabebits $a_k$ = i werden die Werte t2(i), i = 0, 1, bezogen auf den jeweiligen Ausgangszustand,. z.B. m' = 0, generiert. Dieser Vorgang wird für alle Ausgangszustände des Schieberegisters durchgeführt.

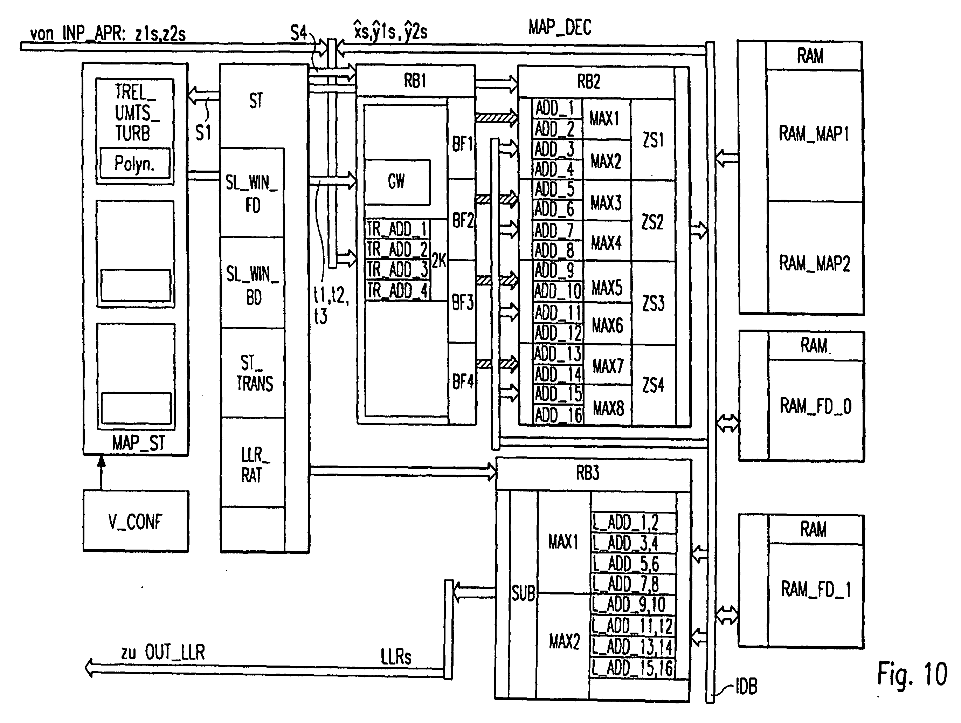

Nachfolgend wird anhand Fig. 10 der Aufbau der Rechenbausteine RB1, RB2 und RB3 erläutert. Die Rechenbausteine RB1, RB2, RB3 sind schnelle Datenpfade, die komplett aus kombinatorischer Logik aufgebaut sind.

Der zur Berechnung der Übergangs-Metrikwerte $\gamma_n^i(R_n, m', m)$ vorgesehene erste Rechenbaustein RB1 nimmt die für $a_k = i$, $i = 0, 1$ erzeugten theoretischen Werte t1(i), t2(i), t3(i) entgegen und setzt diese in einem Schaltkreis GW in Gewichtsfaktoren w1(i), w2(i), w3(i) um. Die Gewichtsfaktoren w1(i), w2(i), w3(i) berechnen sich nach:

$$w1(i) = 1-2{\cdot}t1\,(i)$$

$$w2\,(i) = 1-2{\cdot}t2\,(i)$$

$$w3\,(i) = 1-2{\cdot}t3\,(i) \tag{9}$$

Die Gewichtsfaktoren w1(i), w2(i), w3(i) sind Vorzeichenwerte, d.h. +1, -1. Mit diesen Vorzeichenwerten werden nun durch Multiplikation mit den "Meßwerten" die Übergangs-Metrikwerte $\gamma_n^i(R_n, m', m)$ berechnet.

Im MAP1-Modus stehen als Meßwerte $xs_n$, $y1s_n$ und die Rückkoppel-Information $z2s_n(it\_no)$ zur Verfügung. Die Berechnung der Übergangs-Metrik eines bestimmten der insgesamt 16 Übergänge (siehe Fig. 9a und 9b) erfolgt nach der Gleichung

$$\gamma_n^i(R_n, m', m) = w1\,(i) \cdot \hat{x}s_n + w2\,(i) \cdot \hat{y}1s_n + w3\,(i) \cdot z2s_n(it\_no) \tag{10}$$

Da w1(i), w2(i), w3(i) Vorzeichenwerte sind, kann $\gamma_n^i(R_n, m', m)$ maximal 8 verschiedene Werte annehmen. Da diese Werte symmetrisch zu 0 sind, müssen nur 4 Werte und ihre jeweiligen negierten Werte berechnet werden.

Diese Berechnungen werden parallel, d.h. gleichzeitig mit 4 Addierern TR_ADD_1, TR_ADD_2, .., TR_ADD_4 (von denen jeder gemäß Gleichung (10) drei Eingänge aufweist) und der nachgeschalteten Zweier-Komplement-Stufe 2K in RB1 durchgeführt. Die Zweier-Komplement-Stufe 2K bildet zu einem berechneten Wert den entsprechenden negierten Wert.

Der Zweier-Komplement-Stufe 2K ist ein Demultiplexer (nicht dargestellt) nachgeschaltet. Dieser verteilt die 8 berechneten Übergangs-Metrikwerte $\gamma_n^i(R_n, m', m)$ auf 4 Speicher BF1, BF2, .., BF4 mit jeweils 4 Speicherplätzen.

Die Verteilung wird so vorgenommen, daß in jedem Speicher BF1-4 die Übergangs-Metrikwerte $\gamma_n^i(R_n, m', m)$ eines "Butterfly" abgespeichert sind. Ein Butterfly bezeichnet eine Gruppe bestehend aus 4 bestimmten Übergangs-Metrikwerten $\gamma_n^i(R_n, m', m)$. In Fig. 9c sind die 4 Butterflies dargestellt. Der erste Butterfly B1 umfaßt die 4 Übergangs-Metrikwerte, die auf die Endzustände 0 und 1 hinführen, der zweite Butterfly B2 umfaßt die 4 Übergangs-Metrikwerte, die auf die Endzustände 2 und 3 hinführen, .., und der vierte Butterfly B4 umfaßt die 4 Übergangs-Metrikwerte, die auf die Endzustände 6 und 7 hinführen.

Im MAP2-Modus stehen lediglich zwei "Meßwerte" $\hat{y}2s_n$ und $z1s_n(it\_no)$ zur Verfügung. Die Berechnung des Übergangs-Metrikwertes eines bestimmten der insgesamt 16 Übergänge erfolgt nach der Gleichung:

$$\gamma_n^i(G_n, m', m) = w2\,(i) \cdot \hat{y}2s_n + w3\,(i) \cdot z1s_n\,(it\_no) \tag{11}$$

(hierbei wird mit $G_n$ die Folge bestehend aus den Wertepaaren $(z1_n, \hat{y}2_n)$ bezeichnet).

Da nur zwei Vorzeichenwerte w2(i), w3(i) zu berücksichtigen sind, kann $\gamma_n^i(G_n, m', m)$ maximal 4 verschiedene Werte annehmen. Diese Werte können entweder von den 4 Addierern TR_ADD_1-4 direkt oder durch 2 Addierer und die nachgeschaltete Zweier-Komplement-Stufe 2K berechnet werden.

Der weitere Verarbeitungsweg ist wie beim MAP1-Modus.

Die Steuerung des Rechenbausteins RB1 zur Kombination der theoretischen Werte (bzw. der Gewichtsfaktoren) mit den "Meßwerten" wechselweise gemäß den Gleichungen (10) und (11) erfolgt durch die Steuereinheit ST_TRANS.

Die 16 berechneten Übergangs-Metrikwerte werden durch vier parallele Datenbusleitungen (jeweils eine Datenbusleitung pro Speicher BF1-4) dem zweiten Rechenbaustein RB2 zugeleitet.

Der zweite Rechenbaustein RB2 führt die rekursive Berechnung der Vorwärts- und Rückwärtsrekursions-Metrikwerte durch. Er weist 16 parallel angeordnete Addierer ADD_1, ADD_2, .., ADD_16, 8 parallel angeordnete Maximum-Einheiten MAX1, MAX2, .., MAX8 und 4 parallel angeordnete Zwischenspeicher ZS1, ZS2, ZS3 und ZS4 auf.

Jeder der Addierer ADD_1-4 addiert einen Übergangs-Metrikwert zu einem Vorwärts- oder Rückwärtsrekursions-Metrikwert, welcher im vorhergehenden Rekursionsschritt bestimmt wurde - d.h. im Fall der Vorwärtsrekursion zu einem Ausgangszustand und im Fall der Rückwärtsrekursion zu einem Endzustand.

Für die Berechnung der Vorwärtsrekursions-Metrikwerte betrachten wir zunächst exemplarisch das Butterfly B1. Der erste Addierer ADD_1 addiert zu dem im vorhergehenden Rekursionsschritt errechneten Vorwärtsrekursions-Metrikwert $\alpha_{n-1}(m' = 0)$ die Übergangs-Metrik $\gamma_n^0(R_n, m' = 0, m = 0)$, wobei sich ein erster möglicher Wert $\alpha_n^0(m = 0)$ für den neuen Vorwärtsrekursions-Metrikwert $\alpha_n(m = 0)$ ergibt, und der zweite Addierer ADD_2 addiert zu dem im vorhergehenden Rekursionsschritt errechneten Vorwärtsrekursions-Metrikwert $\alpha_{n-1}(m' = 4)$ die Übergangs-Metrik $\gamma_n^1(R_n, m' = 4, m = 0)$, wobei sich ein zweiter möglicher Wert $\alpha_n^1(m = 0)$ für den neuen Vorwärtsrekursions-Metrikwert $\alpha_n(m = 0)$ ergibt. Der hochgestellte Index der möglichen Vorwärtsrekursions-Metrikwerte gibt das den jeweiligen Übergang bewirkende Eingabebit an.

Diese beiden Möglichkeiten, zum Endzustand m = 0 zu gelangen, sind gemäß dem obersten in Fig. 9c dargestellten Butterfly B1 alternativ.

Die weiteren Addierer arbeiten in analoger Weise, d.h. die Addierer ADD_3 und ADD_4 berechnen entsprechende Ausdrücke bezüglich der beiden Alternativen, um zu dem anderen Endzustand m = 1 des erstes Butterfly B1 zu gelangen, usw..

Allgemein gilt, daß jedem solchen alternative Übergangs-Metrikwerte verarbeitenden Paar von Addierern ADD_1/2, ADD_3/4, .., ADD_15/16 jeweils eine Maximum-Einheit MAX1, MAX2, .., MAX8 nachgeschaltet ist. Die Maximum-Einheiten MAX1, MAX2, .., MAX8 wählen durch Verwerfen jeweils des kleineren der beiden möglichen Werte $\alpha_n^0(m)$, $\alpha_n^1(m)$ für $\alpha_n(m)$ den wahrscheinlicheren der beiden alternativen Übergänge aus. Diese Vorwärtsrekursions-Metrikwerte $\alpha_n(m)$ bilden den Ausgangspunkt für den nächsten Rekursionsschritt n nach n+1.

In RB2 werden daher gleichzeitig 8 Vorwärtsrekursions-Metrikwerte $\alpha_n(m)$ für 4 Butterflies in paralleler Datenverarbeitung bestimmt. Die 8 berechneten Vorwärtsrekursions-Metrikwerte $\alpha_n(m)$ werden temporär zum Zwecke der Rekursionsberechnung in den Zwischenspeichern ZS1, ZS2, ZS3, ZS4 abgelegt. Die Ergebnisse $\alpha_n^0(m)$ und $\alpha_n^1(m)$ der Addierer ADD_1-16 werden über den Datenbus IDB den Vorwärtsrekursions-Speicherbereichen RAM_FD_0 bzw. RAM_FD_1 zugeleitet und dort abgespeichert. Sie werden später im Rechenbaustein RB3 verwendet.

Bei der in UMTS eingesetzten Datenrate von 384 kbit/s müssen alle 16 möglichen Vorwärtsrekursions-Metrikwerte $\alpha^0(m)$, $\alpha^1(m)$ innerhalb eines 52 MHz-Zyklus berechnet und in den vorwärtsrekursions-Speicherbereichen RAM_FD_0 und RAM_FD_1 gespeichert werden.

Die Berechnung der Rückwärtsrekursions-Metrikwerte erfolgt analog, jedoch auf der Grundlage von Übergängen von einem Endzustand m zu einem Anfangszustand m'. Die bei der Rückwärtsrekursion für den betrachteten Zeitpunkt n berechneten Rückwärtsrekursions-Metrikwerte werden ebenfalls temporär (d.h. nur zum Zwecke der Rekursion zur Verwendung in dem jeweils nächsten Rekursionsschritt) in dem jeweiligen Zwischenspeicher ZS1, ZS2, ZS3 bzw. ZS4 abgelegt. Die Zwischenspeicher beinhalten somit die Vorwärts- und Rückwärtsrekursions-Metrikwerte eines Butterflies für einen bestimmten Zeitpunkt n.

Eine Abspeicherung der berechneten Rückwärtsrekursions-Metrikwerte über den Rekursionslauf ist (anders wie bei den Vorwärtsrekursions-Metrikwerten in RAM_FD_0 bzw. RAM_FD_1) nicht erforderlich, da die Rückwärtsrekursions-Metrikwerte im dritten Rechenbaustein RB3 sofort weiterverarbeitet werden können.

Der zur Berechnung der LLR-Ausgabewerte vorgesehene dritte Rechenbaustein RB3 umfaßt 16 Addierer L_ADD_1, L_ADD_2, .., L_ADD_16, zwei Maximum-Einheiten MAX_1 und MAX_2 sowie einen Subtrahierer SUB.

Der dritte Rechenbaustein RB3 setzt die in der Gleichung (5) angegebene Beziehung gemäß einem Näherungsausdruck

$$\max_{m=0,\ldots,7} \{ \alpha_n^1(m) + \beta_n(m) \} \; - \; \max_{m=0,\ldots,7} \{ \alpha_n^0(m) + \beta_n(m) \}$$

für die Berechnung der LLRs um. Der Näherungsausdruck ist in dem Artikel "Comparision of Turbo-Code Decoders Applied to Short Frame Transmission Systems", Peter Jung, IEEE Journal of Selected Areas in Communications, Vol. 14, No. 3, April 1996 vorgeschlagen, welcher durch Bezugnahme Gegenstand der vorliegenden Schrift wird. Die ersten 8 Addierer L_ADD_1-8 sind für die Addition der Vorwärtsrekursions-Metrikwerte zu i = 1 mit den zugehörigen Rückwärtsrekursions-Metrikwerten (d.h. für die Hypothese $u_n = 1$) zuständig, d.h. jeder Addierer bildet für einen der 8 Zustände die Summe $\alpha_n^1(m) + \beta_n(m)$. Die zweiten 8 Addierer L_ADD_9-16 sind für die Addition der Vorwärtsrekursions-Metrikwerte zu i = 0 mit den zugehörigen Rückwärtsrekursions-Metrikwerten (d.h. für die Hypothese $u_n = 0$) zuständig, d.h. jeder Addierer bildet für einen der 8 Zustände die Summe $\sigma_n^0(m) + \beta_n(m)$.

Die Maximum-Einheit MAX_1 nimmt die Ausgänge der ersten 8 Addierer L_ADD_1-8 entgegen und die Maximum-Einheit MAX_2 nimmt die Ausgänge der zweiten 8 Addierer L_ADD_9-16 entgegen. Jede Maximum-Einheit MAX_1 bzw. MAX_2 findet durch Vergleich aller acht Addierer-Ausgänge den jeweils maximalen Addierer-Ausgang und leitet diesen dem Subtrahierer SUB weiter. Damit ist unter allen Übergängen verursacht durch ein Eingabebit i = 1 durch MAX_1 der Wert mit der maximalem Wahrscheinlichkeit und unter allen Übergängen verursacht durch ein Eingabebit i = 0 durch MAX_2 der Wert mit der maximalem Wahrscheinlichkeit bestimmt. Der Subtrahierer SUB berechnet unter Anwendung der Logarithmus-Eigenschaft ln (a/b) = ln(a) - ln(b) als Differenz dieser Ergebniswerte die Zuverlässigkeitsinformation, d.h. den LLR-Wert $z1_n(it\_no)$ (im MAP1-Modus) bzw. den LLR-Wert $z2_n$ $(it\_no)$ (im MAP2-Modus).

Da sowohl in dem zweiten Rechenbaustein RB2 als auch in dem dritten Rechenbaustein RB3 jeweils 16 Addierer enthalten sind, können diese beiden Rechenbausteine auch in einem gemeinsamen Rechenbaustein mit insgesamt ebenfalls nur 16 Addierern zusammengefaßt werden. In diesem Fall werden die 16 Addierer gemultiplext betrieben, d.h. die Vorwärts- und Rückwärtsrekursions-Metrikwerte und die LLRs müssen alternierend berechnet werden. Der Vorteil besteht in einer Reduzierung des Hardware-Aufwands.

**Patentansprüche**

1. Turbo-Decodierer zum Decodieren eines senderseitig mit einem Turbo-Code fehlerschutzcodierten, über einen gestörten Kanal übertragenen und in einem Empfänger (E) detektierten Datensignals (D), mit

   - wenigstens einem Symbolschätzer (MAP_DEC), welcher umfaßt:

     -- einen Eingang (IF) zur Entgegennahme von auf das detektierte Datensignal (D) zurückgehenden Datensymbolen,
     -- einen Ausgang zur Bereitstellung von Ausgabewerten (LLR), auf deren Basis geschätzte Datensymbole des senderseitig der Fehlerschutzcodierung zugrundeliegenden Datensignals (U) ermittelbar sind, und
     -- ein Rechenmittel (RM), welches mit Kenntnis des senderseitig eingesetzten Fehlerschutzcodes

        --- Übergangs-Metrikwerte,
        --- Vorwärts- und Rückwärtsrekursions-Metrikwerte, und daraus
        --- die Ausgabewerte (LLR)
        berechnet und welches einen aus kombinatorischer Logik aufgebauten ersten Hardware-Rechenbaustein (RB1) zur Erzeugung der Übergangs-Metrikwerte enthält,

   **dadurch gekennzeichnet,**

   - **daß** der Symbolschätzer (MAP_DEC) ein Steuermittel (ST_TRANS) zur Steuerung des ersten Hardware-Rechenbausteins (RB1) aufweist, welches bewirkt, daß der erste Rechenbaustein (RB1) die Übergangs-Metrikwerte wechselweise nach einer ersten und einer zweiten Rechenvorschrift bestimmt.

2. Turbo-Decodierer nach Anspruch 1,
   **dadurch gekennzeichnet,**

   - **daß** der erste Hardware-Rechenbaustein (RB1) zur Erzeugung von Übergangs-Metrikwerten

     -- vier parallel angeordnete Addierer (TR_ADD_1-4) und wenigstens eine den Addierern nachgeschaltete Zweier-Komplement-Stufe (2K) umfaßt.

3. Turbo-Decodierer nach Anspruch 1,
   **dadurch gekennzeichnet,**

   - **daß** der erste Hardware-Rechenbaustein (RB1) zur Erzeugung von Übergangs-Metrikwerten

     -- acht parallel angeordnete Addierer umfaßt.

4. Turbo-Decodierer nach Anspruch 2 oder 3,
   **dadurch gekennzeichnet,**

   - **daß** der erste Hardware-Rechenbaustein (RB1) zur Erzeugung von Übergangs-Metrikwerten vier Speicher (BF) zur Abspeicherung von jeweils vier Übergangs-Metrikwerten enthält.

5. Turbo-Decodierer nach einem der vorhergehenden Ansprüche,
**dadurch gekennzeichnet,**

- **daß** der Symbolschätzer (MAP_DEC) ein Modul (MAP_ST) zum Erzeugen von standardspezifischer Code-Information für mehrere unterschiedliche Mobilfunkstandards, insbesondere für UMTS und GSM, umfasst und der erste Hardware-Rechenbaustein (RB1) von der standardspezifischen Code-Information gesteuert wird.

6. Turbo-Decodierer nach einem der vorhergehenden Ansprüche,
**dadurch gekennzeichnet,**

- **daß** das Rechenmittel (RM) einen zweiten Hardware-Rechenbaustein (RB2) zur Erzeugung von Vorwärts- und Rückwärtsrekursions-Metrikwerten enthält, welcher

-- eine Additionsstufe bestehend aus einer Anzahl Q von parallel angeordneten Addierern (ADD_1-16), und
-- eine Maximierungsstufe bestehend aus parallel angeordneten Maximum-Einheiten (MAXI-8) umfaßt, wobei jede Maximum-Einheit (MAX1-8) an ihren Eingängen die Ausgänge von zwei Addierern (ADD-1-16) entgegennimmt und den größeren der Addiererausgänge an ihrem Ausgang ausgibt.

7. Turbo-Decodierer nach Anspruch 6,
**dadurch gekennzeichnet,**

- **daß** Q = 16.

8. Turbo-Decodierer nach einem der Ansprüche 6 oder 7,
**dadurch gekennzeichnet,**

- **daß** der Symbolschätzer (MAP_DEC) ein Steuermittel (SL_WIN_FD, SL_WIN_BD) zur Steuerung des zweiten Hardware-Rechenbausteins (RB2) aufweist, welches bewirkt, daß zur Berechnung der Vorwärts- und Rückwärtsrekursions-Metrikwerte Vorwärts- und Rückwärtsrekursionsintervalle mit gleitenden Intervallgrenzen innerhalb eines Datenblocks eingesetzt werden.

9. Turbo-Decodierer nach einem der vorhergehenden Ansprüche,
**dadurch gekennzeichnet,**

- **daß** das Rechenmittel (RM) einen dritten Hardware-Rechenbaustein (RB3) zur Erzeugung von Ausgabewerten (LLRs) umfaßt, welcher

-- eine Additionsstufe bestehend aus einer Anzahl P von parallel angeordneten Addierern (L_ADD_1-16), und
-- eine Maximierungsstufe bestehend aus zwei parallel angeordneten Maximum-Einheiten (MAX_1, MAX_2) umfaßt, wobei jede Maximum-Einheit (MAX_1, MAX_2) an ihren Eingängen die Ausgänge von P/2 Addierern entgegennimmt und den größten der Addiererausgänge an ihrem Ausgang ausgibt.

10. Turbo-Decodierer nach Anspruch 9,
**dadurch gekennzeichnet,**

- **daß** P = 16.

11. Turbo-Decodierer nach Anspruch 9 oder 10,
**dadurch gekennzeichnet,**

- **daß** der dritte Hardware-Rechenbaustein (RB3) zur Erzeugung der Ausgabewerte (LLRs) einen Subtrahierer (SUB) zur Bildung der Differenz der Ausgänge der beiden Maximum-Einheit (MAX_1, MAX_2) aufweist.

12. Turbo-Decodierer nach einem der vorhergehenden Ansprüche,
**dadurch gekennzeichnet,**

- **daß** der Symbolschätzer (MAP_DEC) ein Steuermittel (LLR_RAT) zur Steuerung des dritten Hardware-Rechenbausteins (RB3) aufweist, welches bewirkt, daß der dritte Rechenbaustein (RB3) Vorwärts- und Rückwärtsrekursions-Metrikwerte innerhalb von gleitenden Intervallgrenzen kombiniert.

**13.** Turbo-Decodierer nach einem der Ansprüche 6 bis 12,
**dadurch gekennzeichnet,**

- **daß** der zweite Hardware-Rechenbaustein (RB2) zur Erzeugung von Vorwärts- und Rückwärtsrekursions-Metrikwerten und der dritte Hardware-Rechenbaustein (RB3) zur Erzeugung der Ausgabewerte (LLRs) gemeinsame, im Multiplexbetrieb arbeitende Addierer (ADD_1-16 bzw. L_ADD_1-16) verwenden.

**14.** Turbo-Decodierer nach einem der vorhergehenden Ansprüche,
**dadurch gekennzeichnet,**

- **daß** der Turbo-Decodierer (TDEC) ferner

-- einen digitalen Signalprozessor (DSP) zur

--- Durchführung von Turbo-Ver- und Entschachtelungsprozeduren und
--- zur Berechnung von für den momentanen Kanalzustand repräsentativer statistischer Information gemäß einem vorgegebenen Ablaufprogramm, und

-- eine bidirektionale Schnittstelle (FMI), über welche der digitalen Signalprozessor (DSP) mit dem Symbolschätzer (MAP_DEC) in Datenaustauschverbindung steht,

umfaßt.

**15.** Turbo-Decodierer nach einem der vorhergehenden Ansprüche,
**dadurch gekennzeichnet,**

- **daß** der Symbolschätzer (MAP_DEC) während eines Iterationsdurchlaufs sowohl zur Berechnung von erster als auch zur Berechnung von zweiter Zuverlässigkeitsinformation eingesetzt wird.

**Claims**

**1.** Turbo decoder for decoding a data signal (D) error-protection-coded with a turbo code at the transmitter end, transmitted via a disturbed channel and detected in a receiver (E) comprising

- at least one symbol estimator (MAP_DEC) which comprises the following:

-- an input (IF) for receiving data symbols attributable to the detected data signal (D),
-- an output for providing output values (LLR), on the basis of which estimated data symbols of the data signal (U) forming the basis for the error protection coding at the transmitter end can be determined, and
-- a computing means (RM) which, with, knowledge of the error protection code used at the transmitter end, calculates

--- transition metric values,
--- forward and reverse recursion metric values and, from these,
--- the output values (LLR), and which contains a first hardware computing chip (RB1), constructed of combinatorial logic, for generating the transition metric values,

**characterized in that**

- the symbol estimator (MAP_DEC) has a control means (ST_TRANS) for controlling the first hardware computing chip (RB1) which has the effect that the first computing chip (RB1) alternately determines the transition metric values according to a first and a second computing rule.

**2.** Turbo decoder according to Claim 1, **characterized in that**

- the first hardware computing chip (RB1) for generating transition metric values comprises

 -- four adders (TR_ADD_1-4) arranged in parallel and at least one twos complement stage (2K) following the adders.

3. Turbo decoder according to Claim 1, **characterized in that**

 - the first hardware computing chip (RB1) for generating transition metric values comprises

 -- eight adders arranged in parallel.

4. Turbo decoder according to Claim 2 or 3,
 **characterized in that**

 - the first hardware computing chip (RB1) for generating transition metric values contains four memories (BF) for storing in each case four transition metric values.

5. Turbo decoder according to one of the preceding claims,
 **characterized in that**

 - the symbol estimator (MAP_DEC) comprises a module (MAP_ST) for generating standard-specific code information for a plurality of different mobile radio standards, in particular for UMTS and GSM and the first hardware computing chip (RB1) is controlled by the standard-specific code information.

6. Turbo decoder according to one of the preceding claims,
 **characterized in that**

 - the computing means (RM) contains a second hardware computing chip (RB2) for generating forward and reverse recursion metric values, which comprises

 -- an addition stage consisting of a number Q of adders (ADD_1-16) arranged in parallel and
 -- a maximization stage consisting of maximum units (MAX1-8) arranged in parallel, each maximum unit (MAX1-8) receiving at its inputs the outputs from two adders (ADD1-16) and outputting the larger one of the adder outputs at its output.

7. Turbo decoder according to Claim 6,
 **characterized in that**

 - Q = 16.

8. Turbo decoder according to one of Claims 6 or 7,
 **characterized in that**

 - the symbol estimator (MAP_DEC) has a control means (SL_WIN_FD, SL_WIN_BD) for controlling the second hardware computing chip (RB2), which has the effect that forward and reverse recursion intervals having sliding interval boundaries are used within a datablock for calculating the forward and reverse recursion metric values.

9. Turbo decoder according to one of the preceding claims,
 **characterized in that**

 - the computing means (RM) comprises a third hardware computing chip (RB3) for generating output values (LLRs), which comprises

 -- an addition stage consisting of a number P of adders (L_ADD_1-16) arranged in parallel and
 -- a maximization stage consisting of two maximum units (MAX_1, MAX_2) arranged in parallel, each maximum unit (MAX_1, MAX_2) receiving at its inputs the outputs from P/2 adders and outputting the largest one of the adder outputs at its output.

**10.** Turbo decoder according to Claim 9,
**characterized in that**

- P = 16.

**11.** Turbo decoder according to Claim 9 or 10,
**characterized in that**

- the third hardware computing chip (RB3) has a subtractor (SUB) for forming the difference between the outputs of the two maximum units (MAX_1, MAX_2) for generating the output values (LLRs).

**12.** Turbo decoder according to one of the preceding claims,
**characterized in that**

- the symbol estimator (MAP_DEC) has a control means (LLR_RAT) for controlling the third hardware computing chip (RB3) which has the effect that the third computing chip (RB3) combines forward and reverse recursion metric values within sliding interval boundaries.

**13.** Turbo decoder according to one of Claims 6 to 12,
**characterized in that**

- the second hardware computing chip (RB2) for generating forward and reverse recursion metric values and the third hardware computing chip (RB3) for generating the output values (LLRs) use common adders (ADD_1-16 and L_ADD_1-16), operating in multiplex operation.

**14.** Turbo decoder according to one of the preceding claims,
**characterized in that**

- the turbo decoder (TDEC) also comprises

-- a digital signal processor (DSP) for

--- carrying out the turbo interleaving and deinterleaving procedures and
--- for calculating statistical information representative of the instantaneous channel state in accordance with a predetermined sequence program, and

-- a bidirectional interface (FMI) via which the digital signal processor (DSP) is connected to the symbol estimator (MAP_DEC) to exchange data.

**15.** Turbo decoder according to one of the preceding claims,
**characterized in that**

- the symbol estimator (MAP_DEG) is used both for calculating first reliability information and for calculating second reliability information during an iteration pass.


**Revendications**

**1.** Décodeur turbo pour le décodage d'un signal de données (D̂) qui est codé côté émetteur avec un code turbo pour la protection contre les erreurs, qui est transmis par l'intermédiaire d'un canal parasité et qui est détecté dans un récepteur (E), comportant

- au moins un estimateur de symboles (MAP_DEC) qui comprend :

-- une entrée (IF) pour la réception de symboles de données se rapportant au signal de données détecté (D̂),
-- une sortie pour la fourniture de valeurs de sortie (LLR) sur la base desquelles peuvent être déterminés des symboles de données estimés du signal de données (U) à la base du codage de protection contre les erreurs côté émetteur, et

-- un moyen de calcul (RM) qui calcule, en connaissant le code de protection contre les erreurs utilisé côté émetteur,

--- des valeurs métriques de transition,
--- des valeurs métriques de récurrence en avant et en arrière, et
--- à partir de là, les valeurs de sortie (LLR) et qui contient un premier module matériel de calcul (RB1) structuré selon une logique combinatoire pour la production des valeurs métriques de transition,

**caractérisé par le fait que**

- l'estimateur de symboles (MAP_DEC) comporte un moyen de commande (ST_TRANS) qui est destiné à la commande du premier module matériel de calcul (RB1) et qui fait en sorte que le premier module de calcul (RB1) détermine les valeurs métriques de transition en alternance selon une première règle de calcul et selon une deuxième règle de calcul.

2. Décodeur turbo selon la revendication 1,
   **caractérisé par le fait que**

   - le premier module matériel de calcul (RB1) comprend pour la production de valeurs métriques de transition

     -- quatre additionneurs (TR_ADD_1-4) montés en parallèle et au moins un étage de complément à deux (2K) monté du côté aval des additionneurs.

3. Décodeur turbo selon la revendication 1,
   **caractérisé par le fait que**

   - le premier module matériel de calcul (RB1) comprend pour la production de valeurs métriques de transition

     -- huit additionneurs montés en parallèle.

4. Décodeur turbo selon la revendication 2 ou 3,
   **caractérisé par le fait que**

   - le premier module matériel de calcul (RB1) contient pour la production de valeurs métriques de transition quatre mémoires (BF) pour la mémorisation de quatre valeurs métriques de transition à chaque fois.

5. Décodeur turbo selon l'une des revendications précédentes,
   **caractérisé par le fait que**

   - l'estimateur de symboles (MAP_DEC) comprend un module (MAP_ST) pour la production d'une information de code spécifique au standard pour plusieurs standards différents de radiocommunication mobile, notamment pour UMTS et GSM, et le premier module matériel de calcul (RB1) est commandé par l'information de code spécifique au standard.

6. Décodeur turbo selon l'une des revendications précédentes,
   **caractérisé par le fait que**

   - le moyen de calcul (RM) contient un deuxième module matériel de calcul (RB2) qui est destiné à la production de valeurs métriques de récurrence en avant et en arrière et qui comprend

     -- un étage d'addition constitué d'un nombre Q d'additionneurs (ADD_1-16) montés en parallèle, et
     -- un étage de maximisation constitué d'unités de maximum (MAX1-8) montées en parallèle, chaque unité de maximum (MAX1-8) recevant à ses entrées les sorties de deux additionneurs (ADD_1-16) et fournissant à sa sortie la plus grande des sorties d'additionneur.

7. Décodeur turbo selon la revendication 6,
   **caractérisé par le fait que** Q = 16.

**8.** Décodeur turbo selon l'une des revendications 6 ou 7,
   **caractérisé par le fait que**

- l'estimateur de symboles (MAP_DEC) comporte un moyen de commande (SL_WIN_FD, SL_WIN_BD) qui est destiné à la commande du deuxième module matériel de calcul (RB2) et qui fait en sorte que des intervalles de récurrence en avant et en arrière ayant des limites d'intervalle glissantes à l'intérieur d'un bloc de données soient utilisés pour le calcul des valeurs métriques de récurrence en avant et en arrière.

**9.** Décodeur turbo selon l'une des revendications précédentes,
   **caractérisé par le fait que**

- le moyen de calcul (RM) comprend un troisième module matériel de calcul (RB3) qui est destiné à la production de valeurs de sortie (LLR) et qui comprend

-- un étage d'addition constitué d'un nombre P d'additionneurs (L_ADD_1-16) montés en parallèle, et
-- un étage de maximisation constitué de deux unités de maximum (MAX_1, MAX_2) montées en parallèle, chaque unité de maximum (MAX_1, MAX_2) recevant à ses entrées les sorties de P/2 additionneurs et fournissant à sa sortie la plus grande des sorties d'additionneur.

**10.** Décodeur turbo selon la revendication 9,
   **caractérisé par le fait que** P = 16.

**11.** Décodeur turbo selon la revendication 9 ou 10,
   **caractérisé par le fait que**

- le troisième module matériel de calcul (RB3) pour la production des valeurs de sortie (LLR) comporte un soustracteur (SUB) pour la formation de la différence des sorties des deux unités de maximum (MAX_1, MAX_2).

**12.** Décodeur turbo selon l'une des revendications précédentes,
   **caractérisé par le fait que**

- l'estimateur de symboles (MAP_DEC) comporte un moyen de commande (LLR_RAT) qui est destiné à la commande du troisième module matériel de calcul (RB3) et qui fait en sorte que le troisième module de calcul (RB3) combine des valeurs métriques de récurrence en avant et en arrière à l'intérieur de limites d'intervalle glissantes.

**13.** Décodeur turbo selon l'une des revendications 6 à 12,
   **caractérisé par le fait que**

- le deuxième module matériel de calcul (RB2) destiné à la production de valeurs métriques de récurrence en avant et en arrière et le troisième module matériel de calcul (RB3) destiné à la production des valeurs de sortie (LLR) utilisent des additionneurs communs (ADD_1-16 respectivement L_ADD_1-16) fonctionnant en multiplex.

**14.** Décodeur turbo selon l'une des revendications précédentes,
   **caractérisé par le fait que**

- le décodeur turbo (TDEC) comprend en plus

-- un processeur de signal numérique (DSP)
-- pour la mise en oeuvre de procédures d'imbrication et de désimbrication turbo, et

--- pour le calcul d'une information statistique représentative pour l'état momentané de canal, et

-- une interface bidirectionnelle (FMI) par l'intermédiaire de laquelle le processeur de signal numérique (DSP) est en liaison avec l'estimateur de symboles (MAP_DEC) pour l'échange de données.

**15.** Décodeur turbo selon l'une des revendications précédentes,
**caractérisé par le fait que**
l'estimateur de symboles (MAP_DEC) est utilisé pendant un pas d'itération aussi bien pour le calcul d'une première information de fiabilité que pour le calcul d'une deuxième information de fiabilité.

Fig. 1

Fig. 2

$u_1, u_2, ..., u_N$
U

$x_1, x_2, ..., x_N$
X

RSC1

ADD1

T   T   T

ADD2

$y^1{}_1, y^1{}_2, ..., y^1{}_N$
Y1

Fig. 3

Fig. 4

EP 1 269 633 B1

Fig. 5

EP 1 269 633 B1

Fig. 6

Fig. 7

VR1

1.20 LLR's

RR1

n = 0

19

79

n = 0

VR2

2.20 LLR's

RR2

n = 20

39

99

n = 20

Fig. 8

EP 1 269 633 B1

Fig. 9a

Fig. 9b

Fig. 9c

Fig. 9d

EP 1 269 633 B1

Fig. 10

EP 1 269 633 B1